# EUROPÄISCHE PATENTSCHRIFT

(11) **EP 3 752 886 B1**
(45) Veröffentlichungstag und Bekanntmachung des Hinweises auf die Patenterteilung: **29.11.2023**
(21) Anmeldenummer: 19711500.9
(22) Anmeldetag: 11.02.2019
(51) Int. Cl.: G03F 7/20

(54) **BILDSENSOR, POSITIONSSENSORVORRICHTUNG, LITHOGRAPHIEANLAGE UND VERFAHREN ZUM BETREIBEN EINES BILDSENSORS**
IMAGE SENSOR, POSITION SENSOR DEVICE, LITHOGRAPHY SYSTEM AND METHOD FOR OPERATING AN IMAGE SENSOR
CAPTEUR D'IMAGE, DISPOSITIF CAPTEUR DE POSITION, SYSTÈME DE LITHOGRAPHIE ET PROCÉDÉ POUR FAIRE FONCTIONNER D'UN CAPTEUR D'IMAGE

(30) Priorität: 12.02.2018 DE 102018202096
(43) Veröffentlichungstag der Anmeldung: 23.12.2020
(73) Patentinhaber: Carl Zeiss SMT GmbH, 73447 Oberkochen (DE)
(72) Erfinder: HORN, Jan, 80636 München (DE); BIHR, Ulrich, 73467 Kirchheim / Dirgenheim (DE); ZOTT, Andy, 89547 Gerstetten (DE); DEGUENTHER, Markus, 61197 Florstadt (DE)
(74) Vertreter: Horn Kleimann Waitzhofer Schmid-Dreyer Patentanwälte- und Rechtsanwälte PartG mbB
(86) Internationale Anmeldenummer: PCT/EP2019/053298
(87) Internationale Veröffentlichungsnummer: WO 2019/155053

(56) Entgegenhaltungen:
- EP-A1- 0 070 017
- DE-A1-102015 209 259
- US-A- 4 601 537
- US-A1- 2013 050 674

## Beschreibung

Die vorliegende Erfindung betrifft einen Bildsensor für eine Positionssensorvorrichtung, eine Positionssensorvorrichtung mit einem solchen Bildsensor, eine Lithographieanlage mit einer solchen Positionssensorvorrichtung und ein Verfahren zum Betreiben des Bildsensors.

Lithographieanlagen werden beispielsweise bei der Herstellung von integrierten Schaltungen bzw. ICs verwendet, um ein Maskenmuster in einer Maske auf ein Substrat, wie z.B. einem Siliziumwafer, abzubilden. Dabei wird ein von einem optischen System erzeugtes Lichtbündel durch die Maske auf das Substrat gerichtet.

Die darstellbare Strukturgröße hängt dabei stark von der verwendeten Lichtwellenlänge ab. Um besonders kleine Strukturen zu erreichen, ist es erwünscht, besonders kurzwellige Strahlung zu verwenden. EUV-Lithographieanlagen verwenden Licht mit einer Wellenlänge im Bereich von 5 nm bis 30 nm, insbesondere 13,5 nm. "EUV" steht für "Extreme Ultraviolet". Bei solchen Lithographieanlagen müssen wegen der hohen Absorption der meisten Materialien von Licht dieser Wellenlänge reflektierende Optiken, d.h. Spiegel, anstelle von brechenden Optiken, d.h. Linsen, eingesetzt werden. Außerdem muss das Gehäuse, in dem sich die abbildende Optik befindet, evakuiert sein, da bereits die Anwesenheit eines Gases zu einer großen Absorption der Strahlung führen kann.

Die Spiegel können z.B. an einem Tragrahmen (Engl.: force frame) befestigt und wenigstens teilweise manipulierbar oder verkippbar ausgestaltet sein, um eine Bewegung eines jeweiligen Spiegels in bis zu sechs Freiheitsgraden und damit eine hochgenaue Positionierung der Spiegel zueinander, insbesondere im pm-Bereich, zu ermöglichen. Somit können etwa im Betrieb der Lithographieanlage auftretende Änderungen der optischen Eigenschaften, z.B. infolge von thermischen Einflüssen, ausgeregelt werden.

Für das Ausrichten der Spiegel, insbesondere in den sechs Freiheitsgraden, sind diesen Aktuatoren zugeordnet, welche über einen Regelkreis angesteuert werden. Als Teil des Regelkreises ist beispielsweise eine Vorrichtung zur Überwachung des Kippwinkels eines jeweiligen Spiegels vorgesehen.

Das Dokument DE 10 2015 209 259 A1 beschreibt eine Positionssensorvorrichtung, bei welcher ein Bildsensor ein mit einem Spiegel gekoppeltes Muster erfasst, wobei eine bekannte Beziehung zwischen dem Bild des Musters auf dem Bildsensor und einer Auslenkung des Spiegels aus einer Ruhelage besteht. Somit kann von dem durch den Bildsensor aufgenommenen Bild auf die Position des Spiegels relativ zu der Ruhelage geschlossen werden.

Das Dokument US 4 601 537 A offenbart eine Einrichtung zum Beleuchten und Abbilden eines Objekts. Die Einrichtung umfasst dabei verschiedene optische Faserbündel, um das Objekt zu beleuchten und um Lichtsignale des Objekts auf einen digitalen Fotosensor abzubilden. Mittels eines optischen Demultiplexers kann ein digitales Abbild des Objekts mit einer hohen Auflösung unter Verwendung eines Sensors mit einer geringen Auflösung erhalten werden.

Das Dokument US 2013/050674 A offenbart eine Lithographieanlage mit einem Probentisch und einem Ausrichtungssensor, der zum Bestimmen der Ausrichtung des Probentisches relativ zu einer Lithographiemaske eingerichtet ist. Der Ausrichtungssensor umfasst integrierte optische Wellenleiter, die ein Lichtsignal von einer Oberfläche des Sensors zu einem seitlich angeordneten Detektor leiten.

Insbesondere bei evakuierten Belichtungssystemen stellt die Kühlung des Systems ein technisches Problem dar, da ein wärmeübertragendes Medium im Raum zwischen den einzelnen Bauteilen fehlt. Daher ist es erwünscht, verwendet Komponenten derart zu gestalten, dass diese in Betrieb möglichst wenig Wärme generieren.

Vor diesem Hintergrund besteht eine Aufgabe der vorliegenden Erfindung darin, einen verbesserten Bildsensor bereitzustellen.

Gemäß einem ersten Aspekt wird ein Bildsensor für eine Positionssensorvorrichtung zum Ermitteln einer Position zumindest eines Spiegels einer Lithographieanlage vorgeschlagen. Der Bildsensor umfasst eine Mehrzahl N1 von integrierten Lichtwellenleitern, eine Mehrzahl N2 von Einstrahlflächen, mit N2 ≥ N1, wobei eine jeweilige der N2 Einstrahlflächen einem der N1 integrierten Lichtwellenleiter zugeordnet und dazu eingerichtet ist, einfallendes Licht in den zugeordneten integrierten Lichtwellenleiter derart einzukoppeln, dass ein Lichtsignal in dem zugeordneten integrierten Lichtwellenleiter erzeugt wird. Weiterhin weist der Bildsensor eine mit den N1 integrierten Lichtwellenleitern gekoppelte Multiplexer-Vorrichtung zum Multiplexen der in den N1 integrierten Lichtwellenleitern erzeugten Lichtsignale auf eine Anzahl N3 von sekundären Lichtwellenleiten, mit N1 ≥ N3, sowie eine mit den N3 sekundären Lichtwellenleitern gekoppelten Bild-Rekonstruktions-Vorrichtung zum Rekonstruieren eines Bildes in Abhängigkeit der Lichtsignale der N3 sekundären Lichtwellenleiter auf. Die Mehrzahl N2 von Einstrahlflächen, die Mehrzahl N1 von integrierten Lichtwellenleitern und die Multiplexer-Vorrichtung sind auf einem Substrat, insbesondere einem einstückigen Substrat, integriert.

Der Bildsensor kann insbesondere als in drei Baugruppen aufgeteilt betrachtet werden: Eine interne Gruppe, auch Sensor-Frontend genannt, eine Signalverbindung und eine externe Gruppe. Die interne Gruppe ist an dem Ort angeordnet, an welchem ein Bild erfasst werden soll, beispielsweise in einem evakuierten Gehäuse einer Projektionsoptik einer EUV-Lithographieanlage. Die externe Gruppe kann flexibel an einem anderen Ort angeordnet sein, beispielsweise außerhalb des Gehäuses der Projektionsoptik. Die Signalverbindung überträgt insbesondere optische und/oder elektrische Signale zwischen der internen Gruppe und der externen Gruppe.

Dieser Bildsensor weist insbesondere den Vorteil auf, dass zum Erfassen eines Bildes am Ort einer Sensoroberfläche des Bildsensors eine reduzierte Anzahl von elektronischen Komponenten verwendet werden kann. Insbesondere kann die Bild-Rekonstruktions-Vorrichtung an einem von dem Sensor-Frontend entfernt gelegenen Ort angeordneten sein, wie beispielsweise außerhalb einer evakuierten Projektionsoptik einer Lithographieanlage. Die Wandlung der Lichtsignale in ein elektronisch verarbeitbares Signal, insbesondere als ein digitales Bild, erfolgt somit nicht bereits auf oder direkt bei der Sensoroberfläche, wie es beispielsweise bei CCD- oder CMOS-Sensoren der Fall ist, sondern erst in der anderenorts angeordneten Bild-Rekonstruktions-Vorrichtung. Dadurch entsteht in dem Sensor-Frontend weniger Wärmeenergie im Vergleich zu rein elektronischen Bildsensoren.

Das Sensor-Frontend umfasst insbesondere ein Substrat, das als integriert-optischer Bildsensor ausgebildet ist und zumindest die N1 integrierten Lichtwellenleiter und die N2 Einstrahlflächen aufweist. Es kann auch als Chip oder auch als Mikrochip bezeichnet werden. Der integriert-optische Bildsensor kann auch als photonischer Bildsensor bezeichnet werden. Insbesondere weist der Bildsensor zum Erfassen des Bildes einen in integrierter Bauweise hergestellten Chip auf, der beispielsweise eine Schichtstruktur aufweist, in welcher die Mehrzahl N1 von integrierten Lichtwellenleitern und die Mehrzahl N2 von Einstrahlflächen integriert sind. Als Substratmaterial für den Chip kommt insbesondere Silicium, Siliciumoxid, Siliciumkarbid, III-V-Halbleitermaterialien, wie beispielsweise Indiumphosphid, sowie verschiedene Gläser, wie Quarzglas, in Betracht. Zur Erzeugung der integriert-optischen Strukturen, insbesondere der Lichtwellenleiter, kommen in der Mikrochipherstellung bekannte Verfahren zum Einsatz, insbesondere verschiedene Beschichtungs- und/oder Strukturierungsverfahren. Ein derart hergestellter integriert-optischer Chip weist beispielsweise eine Strukturgröße von unter 10 µm auf und ist beispielsweise dazu eingerichtet, eingekoppeltes Licht im Wesentlichen verlustfrei zu übertragen.

Zum Einkoppeln von Licht in die N1 integrierten Lichtwellenleiter sind N2 Einstrahlflächen vorgesehen. Eine Einstrahlfläche ist einem jeweiligen integrierten Lichtwellenleiter zugeordnet. Dabei ist es möglich, dass mehrere Einstrahlflächen demselben integrierten Lichtwellenleiter zugeordnet sind. Die Einstrahlfläche ist insbesondere an einem Anfang des integrierten Lichtwellenleiters, dem sie zugeordnet ist, angeordnet. Unter dem Anfang wird insbesondere ein an der Oberfläche des integriert-optischen Bildsensors angeordnetes Ende des integrierten Lichtwellenleiters verstanden. Die Einstrahlfläche kann beispielsweise als der Anfang des integrierten Lichtwellenleiters betrachtet werden. Die Einstrahlfläche kann insbesondere Beschichtungen, wie beispielsweise Farbfilter, Braggfilter, Antireflexbeschichtungen usw., aufweisen und/oder strukturiert sein. Eine jeweilige Einstrahlfläche ist beispielsweise eine optisch zumindest teilweise transparente Fläche. Die dem integrierten Lichtwellenleiter zugewandte Seite der Einstrahlfläche wird beispielsweise als Einkopplungsseite oder auch als Rückseite bezeichnet. Die dem Raum vor dem integriert-optischen Bildsensor zugewandte Seite wird beispielsweise als Oberfläche der Einstrahlfläche bezeichnet.

Wenn ein Lichtstrahl auf die Oberfläche der Einstrahlfläche einstrahlt oder auf diese einfällt, wird zumindest ein Teil des Lichtstrahls in den integrierten Lichtwellenleiter eingekoppelt und so in dem integrierten Lichtwellenleiter ein Lichtsignal erzeugt. Insbesondere ist unter dem erzeugten Lichtsignal der eingekoppelte Teil des einfallenden Lichtstrahls zu verstehen, im Gegensatz zu einem durch eine Lichtquelle neu erzeugten Lichtsignal. Das erzeugte Lichtsignal hängt insbesondere von Eigenschaften des Lichtstrahls sowie von Eigenschaften der Einstrahlfläche ab. Insbesondere wird eine von dem einfallenden Lichtstrahl transportierte Information auch in das Lichtsignal übertragen. Ferner kann beispielsweise durch eine entsprechende Ausbildung der Einstrahlfläche ein farbgefiltertes Lichtsignal und/oder ein polarisiertes Lichtsignal erzeugt werden, insbesondere ohne dass die ursprüngliche von dem Lichtstrahl transportierte Information verloren geht.

An das andere Ende der N1 integrierten Lichtwellenleiter ist eine Multiplexer-Vorrichtung gekoppelt. Die Multiplexer-Vorrichtung ist insbesondere als ein aktives integriert-optisches Bauteil ausgebildet. Die Multiplexer-Vorrichtung kann auf demselben Chip wie die N2 Einstrahlflächen und die N1 integrierten Lichtwellenleiter integriert sein. Alternativ kann die Multiplexer-Vorrichtung auf einem oder mehreren weiteren Chips integriert sein. Die Multiplexer-Vorrichtung ist dazu eingerichtet, die von den N1 integrierten Lichtwellenleitern zugeführten Lichtsignale auf eine Anzahl von N3 sekundären Lichtwellenleitern zu multiplexen. Hierfür weist die Multiplexer-Vorrichtung beispielsweise eine Anzahl von schaltbaren integriert-optischen Strukturen auf. Die schaltbaren integriert-optischen Strukturen sind beispielsweise als akustooptische und/oder elektrooptische Bauelemente ausgebildet. Die schaltbaren integriert-optischen Strukturen sind dabei insbesondere mittels eines integrierten Elektronikschaltkreises ansteuerbar und/oder schaltbar. In Abhängigkeit einer Schaltposition einer jeweiligen schaltbaren integriert-optischen Struktur wird das Lichtsignal von einem der N1 integrierten Lichtwellenleiter auf einen der N3 sekundären Lichtwellenleiter geschaltet oder gemultiplext. Dabei wird ein das Lichtsignal in den jeweiligen sekundären Lichtwellenleiter eingekoppelt, wodurch in diesem ein entsprechendes Lichtsignal erzeugt wird.

Die N3 sekundären Lichtwellenleiter sind insbesondere keine integrierten Lichtwellenleiter, sondern sind beispielsweise als optische Fasern ausgebildet. Die N3 sekundären Lichtwellenleiter sind daher dazu eingerichtet, die Lichtsignale entlang eines fast beliebig verlaufenden Pfades zu übertragen. Insbesondere ist eine Dämpfung der eingekoppelten Lichtsignale in den N3 sekundären Lichtwellenleitern gering, so dass eine Länge der N3 sekundären Lichtwellenleitern im Bereich von mehreren Metern, beispielsweise bis zu 10 m oder auch bis zu 50 m, betragen kann, und die Lichtsignale dennoch erfassbar sind.

Die N3 sekundären Lichtwellenleiter sind dazu eingerichtet, die eingekoppelten Lichtsignale zu der Bild-Rekonstruktions-Vorrichtung zu leiten. Die Bild-Rekonstruktions-Vorrichtung ist insbesondere dazu eingerichtet, die Lichtsignale von den N3 sekundären Lichtwellenleitern zu erfassen und in Abhängigkeit der erfassten Lichtsignale ein Bild zu rekonstruieren. Die Bild-Rekonstruktions-Vorrichtung weist insbesondere eine Anzahl an elektronischen Bauteilen auf, wie beispielsweise eine oder mehrere Photodioden zum Erfassen und Wandeln der Lichtsignale in elektronische Signale, einen Analog-Digital-Wandler (A/D-Wandler), und/oder einen Bildprozessor. Zum Erfassen der Lichtsignale sind die der Bild-Rekonstruktions-Vorrichtung zugewandten Enden der N3 sekundären Lichtwellenleiter derart angeordnet, dass die Lichtsignale aus den N3 sekundären Lichtwellenleitern austreten und auf die Photodiode einfallen können. Zusätzlich oder alternativ zu der Photodiode kann auch ein CCD-Sensor, ein CMOS-Sensor und/oder ein Photomultiplier vorgesehen sein. Das von der Photodiode in Abhängigkeit der Lichtsignale generierte elektrische Signal wird beispielsweise von einem A/D-Wandler in ein digitales Signal umgewandelt, welches von einem digitalen elektronischen Schaltkreis, wie beispielsweise dem Bildprozessor oder einer CPU, verarbeitbar ist. Der Bildprozessor kann hardwaretechnisch und/oder auch softwaretechnisch implementiert sein. Bei einer hardwaretechnischen Implementierung kann der Bildprozessor zum Beispiel als Computer oder als Mikroprozessor ausgebildet sein. Bei einer softwaretechnischen Implementierung kann der Bildprozessor als Computerprogrammprodukt, als eine Funktion, als eine Routine, als Teil eines Programmcodes oder als ausführbares Objekt ausgebildet sein.

Das von der Bild-Rekonstruktions-Vorrichtung auf diese Weise rekonstruierte Bild weist insbesondere N2 Bildpunkte auf, wobei jeder Bildpunkt des rekonstruierten Bildes eine mit dem auf die jeweilige der N2 Einstrahlflächen einfallenden Licht korrelierte Information aufweist.

Insbesondere werden die Lichtsignale derart erfasst, dass eine eindeutige Zuordnung eines jeweiligen erfassten Lichtsignals zu einer der N2 Einstrahlflächen gewährleistet ist. Hierzu stellt beispielsweise eine Synchronisationseinrichtung, die beispielsweise Teil des Bildprozessors sein kann, ein Synchronisationssignal oder auch Triggersignal bereit. Dieses Synchronisationssignal wird beispielsweise zur Ansteuerung der Multiplexer-Vorrichtung und des A/D-Wandlers verwendet. Unter Berücksichtigung von beispielsweise einer Signallaufzeit ist daher ermittelbar, welchem der N1 integrierten Lichtwellenleiter ein zu einem Zeitpunkt erfasstes und digitalisiertes Lichtsignal zuzuordnen ist. Für den Fall, dass Lichtsignale unterschiedlicher Einstrahlflächen beispielsweise frequenzcodiert sind, wird dies bei der Erfassung der Lichtsignale entsprechend berücksichtigt, beispielsweise durch ein Farbfilterrad.

Nachfolgend beschreibt ein Beispiel die Funktionsweise des Bildsensors. Beispielsweise weist der integriert-optische Bildsensor eine Mehrzahl N2 = 16 Einstrahlflächen auf, die in einer Matrix mit vier Spalten und vier Zeilen angeordnet sind. Man kann auch von einem 4x4-Array sprechen. Beispielsweise weist der integriert-optische Bildsensor eine Mehrzahl N1 = 16 integrierte Lichtwellenleiter auf. Jedem der 16 integrierten Lichtwellenleiter ist genau eine der 16 Einstrahlflächen zugeordnet. Die Multiplexer-Vorrichtung weist beispielsweise vier schaltbare integriert-optische Strukturen auf, die jeweils vier Eingänge auf einen Ausgang multiplexen, wobei jeweils eine der integriert-optischen Strukturen einer Zeile des integriert-optischen Bildsensors zugeordnet ist. Man kann auch von einem 16x4 Multiplexer sprechen. Die vier integrierten Lichtwellenleiter einer Zeile werden den vier Eingängen der schaltbaren integriert-optischen Struktur zugeführt, die der Zeile zugeordnet ist und mit deren Ausgang ein sekundärer Lichtwellenleiter gekoppelt ist. Insgesamt sind in diesem Beispiel somit vier sekundäre Lichtwellenleiter vorgesehen, wobei jeder an eine der schaltbaren integriert-optischen Strukturen der Multiplexer-Vorrichtung ankoppelt. Die vier sekundären Lichtwellenleiter leiten in sie eingekoppelte Lichtsignale an jeweils eine Photodiode der Bild-Rekonstruktions-Vorrichtung, welche daher vier einzelne Photodioden aufweist. Die Synchronisationseinrichtung taktet beispielsweise die vier schaltbaren integriert-optischen Strukturen der Multiplexer-Vorrichtung derart, dass für ein bestimmtes Zeitintervall beispielsweise die Lichtsignale der die erste Spalte bildenden Einstrahlflächen in die sekundären Lichtwellenleiter eingekoppelt werden und von der jeweiligen Photodiode erfasst werden. In einem nächsten Zeitintervall wird beispielsweise umgeschaltet, so dass dann die Lichtsignale der zweiten Spalte erfasst werden usw. Insgesamt lässt sich so eine Bildinformation, beispielsweise ein Muster, die auf der Sensoroberfläche des integriert-optischen Bildsensors mit den N2 Einstrahlflächen vorhanden ist, erfassen. In dem vorangegangenen Beispiel wurden ohne Beschränkung der Allgemeinheit N1 = 16, N2 = 16, N3 = 4 und vier Photodioden gewählt.

Die Mehrzahl N2 von Einstrahlflächen, die Mehrzahl N1 von integrierten Lichtwellenleitern und die Multiplexer-Vorrichtung sind auf einem Substrat, insbesondere einem einstückigen Substrat, integriert.

Der integriert-optische Bildsensor kann somit mit bekannten Herstellungsverfahren auf einem einzelnen Mikrochip ausgebildet werden. Der Mikrochip weist insbesondere sowohl integriert-optische als auch integriert-elektronische Strukturen auf. Beispielsweise weist der integriert-optische Bildsensor zu Ansteuerung der Multiplexer-Vorrichtung Kontaktstellen auf, welche vorderseitig auf dem Mikrochip und/oder rückseitig auf dem Mikrochip angebracht sein können. Über diese Kontaktstellen lässt sich insbesondere das Synchronisationssignal und/oder weitere Steuersignale für die Multiplexer-Vorrichtung auf den Mikrochip übertragen.

Unter einem einstückigen Substrat wird insbesondere verstanden, dass das Substrat für den gesamten integriert-optischen Bildsensor aus demselben Ursprungswafer hergestellt und nicht zusammengefügt ist. Man kann auch von einem monolithisch integrierten Schaltkreis sprechen.

Gemäß einer weiteren Ausführungsform des Bildsensors ist die Multiplexer-Vorrichtung dazu eingerichtet, die Lichtsignale mittels eines Zeitmultiplexverfahrens, eines Frequenzmultiplexverfahrens und/oder eines Codemultiplexverfahrens zu multiplexen.

Bei einem Zeitmultiplexverfahren werden unterschiedliche Signale zeitlich voneinander getrennt. Bei einem Frequenzmultiplexverfahren werden unterschiedliche Signale mit unterschiedlichen Frequenzen zeitgleich übertragen.

Beispielsweise lassen sich solche Signale durch Farbfilter erzeugen und auch durch Farbfilter wieder trennen. Bei einem Codemultiplexverfahren werden mehrere unterschiedliche Signale zeitgleich und mit unterschiedlichen Codefolgen, beispielsweise Spreizcodefolgen, codiert übertragen. Die unterschiedlichen Signale entsprechen insbesondere unterschiedlichen, von den N2 Einstrahlflächen erzeugten Lichtsignalen in den N1 integrierten Lichtwellenleitern.

Falls N1 = N2 ist, lässt sich beispielsweise das Zeitmultiplexverfahren anwenden. Für den Fall N1 < N2 ist beispielsweise ein Frequenzmultiplexverfahren geeignet, um die von unterschiedlichen Einstrahlflächen in einem jeweiligen integrierten Lichtwellenleiter erzeugten Lichtsignale zu diskriminieren. Hierfür weisen beispielsweise die Oberflächen der N2 Einstrahlflächen verschiedene Farbfilter auf.

Gemäß einer weiteren Ausführungsform des Bildsensors weist die Bild-Rekonstruktions-Vorrichtung eine Erfassungseinrichtung zum Erfassen der Lichtsignale der N3 sekundären Lichtwellenleiter und eine Synchronisationseinrichtung auf. Die Synchronisationseinrichtung ist dazu eingerichtet, die Multiplexer-Vorrichtung mittels eines Synchronisationssignals derart anzusteuern, dass ein jeweiliges von der Erfassungseinrichtung erfasstes Lichtsignal eindeutig einer Einstrahlfläche der Mehrzahl N2 von Einstrahlflächen des Bildsensors zuordenbar ist.

Die Erfassungseinrichtung weist insbesondere eine oder mehrere Photodioden, einen CCD-Sensor, einen CMOS-Sensor und/oder einen Photomultiplier auf. Die Synchronisationseinrichtung weist insbesondere einen Taktgeber auf, der ein Taktsignal mit einer bekannten und konstanten Frequenz bereitstellt.

Gemäß einer weiteren Ausführungsform des Bildsensors weist die Oberfläche einer jeweiligen Einstrahlfläche der Mehrzahl N2 von Einstrahlflächen einen vorbestimmten Winkel zu dem einfallenden Licht auf.

Man kann auch von dem Einstrahlwinkel oder Einkopplungswinkel sprechen. Um eine effiziente Einkopplung zu erreichen, kann es vorteilhaft sein, die Oberfläche nicht orthogonal zu dem einfallenden Licht auszurichten, da ein integrierter Lichtwellenleiter nur bestimmte, beispielsweise von Material und Strukturgröße abhängige, Moden transportieren kann. Diese Moden werden von Licht mit bestimmten Wellenvektoren bevorzugt angeregt. Dabei ist auch die Wellenlänge oder die Frequenz des einfallenden Lichts zu berücksichtigen.

Insbesondere kann der Winkel der Oberfläche zweier Einstrahlflächen auch unterschiedlich sein, beispielsweise weil die jeweiligen Einstrahlflächen unterschiedliche Filter aufweisen.

Gemäß einer weiteren Ausführungsform des Bildsensors weist dieser eine Abbildungseinheit zum Abbilden eines mit dem Bildsensor zu erfassenden Musters einer Musterbereitstellungseinrichtung auf die Mehrzahl N2 von Einstrahlflächen des Bildsensors auf.

Die Abbildungseinheit weist beispielsweise eine oder mehrere Linsen auf. Insbesondere kann die Abbildungseinheit auch eine Mikrooptik umfassen, bei der für jede der N2 Einstrahlflächen des integriert-optischen Bildsensors eine oder mehrere Linsen vorgesehen sind.

Die Abbildungseinheit ist insbesondere dazu eingerichtet, am Ort der Sensoroberfläche des integriert-optischen Bildsensors ein Bild des zu erfassenden Musters zu erzeugen. Ferner hat die Abbildungseinheit insbesondere den Vorteil, dass durch sie die Lichtleistung, die auf eine jeweilige Einstrahlfläche einfällt, vergrößert werden kann. So lässt sich einerseits ein Signal-Rausch-Verhältnis verbessern und andererseits eine benötigte Beleuchtungslichtleistung reduzieren, was einen Energieeintrag, beispielsweise in ein evakuiertes Projektionssystem einer Lithographieanlage, reduzieren kann.

Die Abbildungseinheit kann auch dazu geeignet sein, ein Muster, das nicht in einer Ebene liegt, sondern gekrümmt ist, abzubilden. Ferner ist es möglich, die Abbildungseinheit derart auszubilden, dass die Abbildung des Musters in einer schiefen Ebene in Bezug auf eine Sichtlinie von der Sensoroberfläche zu der Musterbereitstellungseinrichtung erfolgt.

Die Musterbereitstellungseinrichtung weist beispielsweise ein Muster mit einem Informationsgehalt bei Ortsfrequenzen von zumindest 1/(500 µm) auf.

Gemäß einer weiteren Ausführungsform des Bildsensors sind eine Anzahl N4 von sekundären integrierten Lichtwellenleitern und eine Anzahl N5 von Ausstrahlflächen, mit N5 ≥ N4, vorgesehen. Eine jeweilige Ausstrahlfläche der N5 Ausstrahlflächen ist einem der N4 sekundären integrierten Lichtwellenleiter zugeordnet und dazu eingerichtet, ein in dem zugeordneten sekundären integrierten Lichtwellenleiter erzeugtes Lichtsignal zum Beleuchten des mit dem Bildsensor zu erfassenden Musters aus dem zugeordneten sekundären integrierten Lichtwellenleiter auszukoppeln.

Die Anzahl N4 von sekundären integrierten Lichtwellenleitern und die Anzahl N5 von Ausstrahlflächen sind beispielsweise auf einem eigenen Substrat integriert oder alternativ hierzu auf dem gleichen Substrat, insbesondere auf dem integriert-optischen Bildsensor oder Chip, integriert. Die Anzahl N4 von sekundären integrierten Lichtwellenleitern und die Anzahl N5 von Ausstrahlflächen bilden zusammengefasst beispielsweise eine Beleuchtungsanordnung. Ein in den N4 sekundären integrierten Lichtwellenleiter erzeugtes Lichtsignal wird zu den N5 Ausstrahlflächen geleitet und dort zumindest teilweise aus dem jeweiligen sekundären integrierten Lichtwellenleiter ausgekoppelt oder abgestrahlt. Unterschiedliche Ausstrahlflächen können dabei, wie auch die Einstrahlflächen, unterschiedliche Eigenschaften aufweisen, um ein vorteilhaftes Abstrahlverhalten zu erreichen. Insbesondere können optische Gitter auf einer jeweiligen Ausstrahlfläche vorgesehen sein, um eine richtungsabhängige Abstrahlung zu erreichen.

Gemäß einer weiteren Ausführungsform des Bildsensors weist dieser eine Beleuchtungseinrichtung zum Erzeugen eines Lichtsignals in einem Beleuchtungs-Lichtwellenleiter auf. Mit dem Beleuchtungs-Lichtwellenleiter ist eine Verteiler-Vorrichtung gekoppelt, welche zum Verteilen des in dem Beleuchtungs-Lichtwellenleiter erzeugten Lichtsignals auf die Anzahl N4 von sekundären integrierten Lichtwellenleitern eingerichtet ist.

Die Beleuchtungseinrichtung umfasst ein oder mehrere Leuchtmittel oder Lichtquellen, wie beispielsweise Laser, Gasentladungslampen, Glühbirnen, Leuchtdioden und/oder Lichtbogenlampen. Die Beleuchtungseinrichtung kann zum Bereitstellen eines vorbestimmten Lichtspektrums eingerichtet sein. Insbesondere kann breitbandiges oder monochromatisches Licht vorgesehen sein. Eine Wellenlänge des Lichts liegt vorteilhaft in einem Bereich zwischen 100 nm und 10 µm.

Ein Beleuchtungs-Lichtwellenleiter ist beispielsweise als eine Glasfaser ausgebildet. Damit ist der Beleuchtungs-Lichtwellenleiter dazu eingerichtet, das in ihm erzeugte Lichtsignal über eine größere Strecke, wie beispielsweise 10 m oder 50 m, zu transportieren. Somit kann die Beleuchtungseinrichtung entfernt von dem Ort, an dem das von der Beleuchtungseinrichtung erzeugte Licht zur Beleuchtung verwendet werden soll, angeordnet sein. Insbesondere lässt sich die Beleuchtungseinrichtung damit auch mit einfachen technischen Mitteln effizient kühlen.

Der oder die Beleuchtungs-Lichtwellenleiter sind mit der Verteiler-Einrichtung gekoppelt. Die Verteiler-Einrichtung ist beispielsweise eine passive integriert-optische Schaltung, die auf dem Chip, auf welchem die N4 sekundären integrierten Lichtwellenleiter integriert sind, angeordnet ist. Die Verteiler-Einrichtung kann auch als Verzweiger oder Splitter bezeichnet werden. Die Verteiler-Einrichtung verteilt das von dem oder den Beleuchtungs-Lichtwellenleiter zugeführte Lichtsignal auf die N4 sekundären integrierten Lichtwellenleiter, welche das Lichtsignal den N5 Ausstrahlflächen zuführen.

Mit dieser Anordnung lässt sich das zu erfassende Muster vorteilhaft beleuchten, ohne dass eine Abwärme einer Lichtquelle in dem Bereich, in dem die Beleuchtung verwendet wird, anfällt.

Gemäß einer weiteren Ausführungsform des Bildsensors sind die Anzahl N4 von sekundären integrierten Lichtwellenleitern und die Anzahl N5 von Ausstrahlflächen und/oder die Verteiler-Vorrichtung auf dem Substrat integriert.

Besonders vorteilhaft lassen sich somit sowohl Bilderfassung als auch Beleuchtung auf einem einzigen integriert-optischen Substrat anordnen.

Gemäß einer weiteren Ausführungsform des Bildsensors ist 16 ≤ N2 ≤ 16384, insbesondere 256 ≤ N2 ≤ 4096.

Die Mehrzahl N2 von Einstrahlflächen legt die Anzahl an Bildpunkten des rekonstruierten Bildes fest. Insbesondere entspricht jeder Bildpunkt in dem rekonstruierten Bild genau einer Einstrahlfläche.

Gemäß einer weiteren Ausführungsform des Bildsensors liegt eine Strukturgröße der N1 integrierten Lichtwellenleiter und/oder der N4 sekundären integrierten Lichtwellenleiter unter 1 µm, vorzugsweise unter 500 nm, insbesondere unter 150 nm.

Je kleiner die Strukturgröße der integrierten Lichtwellenleiter ist, umso höher kann eine Integrationsdichte sein. Mit einer höheren Integrationsdichte lässt sich eine Substratfläche effizienter nutzen, wodurch Produktionskosten gesenkt werden können. Ferner kann eine erhöhte Auflösung eine Qualität der Bilderfassung durch den Bildsensor verbessern.

Gemäß einer weiteren Ausführungsform des Bildsensors liegt eine Kantenlänge eines Pixels des Bildsensors zwischen 5 µm und 500 µm, insbesondere zwischen 40 µm und 160 µm.

In Bezug auf die Sensoroberfläche des Bildsensors entspricht ein Pixel insbesondere einer quadratischen Fläche, innerhalb derer eine jeweilige Einstrahlfläche liegt. Die Einstrahlfläche bildet beispielsweise einen Bruchteil der Pixelfläche.

Bei einer Kantenlänge eines Pixels von 100 µm und N2 = 4096 Einstrahlflächen weist der Bildsensor beispielsweise 64x64 Pixel auf, die beispielsweise in einer quadratischen Matrix angeordnet sind, womit der Bildsensor eine Sensoroberfläche von 6,4 × 6,4 mm² = 40,96 mm² aufweist.

Gemäß einem zweiten Aspekt wird eine Positionssensorvorrichtung zum Ermitteln einer Position zumindest eines Spiegels einer Lithographieanlage vorgeschlagen. Die Positionssensorvorrichtung umfasst eine mit dem Spiegel gekoppelte Musterbereitstellungseinrichtung zur Bereitstellung eines Musters, welches einen Informationsgehalt bei Ortsfrequenzen von zumindest 1/(500 µm) aufweist, einen Bildsensor zum Erfassen des bereitgestellten Musters und zum Bereitstellen eines rekonstruierten Bildes des erfassten Musters, und eine Bildauswerteeinrichtung zum Ermitteln der Position des Spiegels in Abhängigkeit des rekonstruierten Bildes. Der Bildsensor entspricht dem Bildsensor des ersten Aspekts oder einer der Ausführungsformen.

Die vorliegende Positionssensorvorrichtung erfasst ein Bild des bereitgestellten Musters und kann damit auch als bildbasierte Positionssensorvorrichtung oder bildbasierter Positionssensor bezeichnet werden.

Durch die Verwendung des Musters mit einem Informationsgehalt bei Ortsfrequenzen von zumindest 1/(500 µm) kann die vorliegende Positionssensorvorrichtung eine hohe Messgenauigkeit bereitstellen. Dabei bestimmen die Ortsfrequenzen von zumindest 1/(500 µm) eine Mindestgenauigkeit der Positionsbestimmung, welche durch die vorliegende Positionssensorvorrichtung sichergestellt wird. Auch wenn das Muster Ortsfrequenzen von nur bis 1/(500 µm) enthält, sind Messgenauigkeiten von weit genauer als 1 µm möglich.

Durch die bildbasierte Positionssensorvorrichtung können parasitäre Effekte, wie etwa eine Skalierung oder ein Verkippen der Musterbereitstellungseinrichtung relativ zu dem Bildsensor, miterfasst und auch kompensiert werden. Der Bildsensor stellt das rekonstruierte Bild insbesondere als digitales Bild des bereitgestellten Musters bereit. Das digitale Bild ist insbesondere als ein elektrisches Signal oder als eine elektrische Signalfolge ausgebildet, welche eine Information über die Position des Spiegels enthält oder diese repräsentiert.

Insbesondere werden die Lichtsignale, welche das Muster repräsentieren, von dem Bildsensor zunächst rein optisch intern der Bild-Rekonstruktions-Vorrichtung zugeführt und erst von dieser digitalisiert. Durch die räumlich getrennte Signalerfassung und die Digitalisierung der Lichtsignale ist ein hohes Maß an Flexibilität in Bezug auf eine Anordnung sowie auf eine Rechenkapazität der Bild-Rekonstruktions-Vorrichtung gegeben.

Unter einem Muster ist insbesondere eine bearbeitete Oberfläche zu verstehen, wobei die bearbeitete Oberfläche einen Informationsgehalt bei Ortsfrequenzen von zumindest 1/ (500 µm) hat. Beispielsweise ist die bearbeitete Oberfläche eine metallbearbeitete Oberfläche oder eine bedruckte Oberfläche. Die metallbearbeitete Oberfläche kann beispielsweise durch Fräsen oder Schleifen hergestellt sein. Das Material des Musters kann beispielsweise Metall, Silicium oder Glas sein. Beispielsweise kann das Muster auch als metallbearbeitete Oberfläche einer Tragstruktur des Spiegels ausgebildet sein. Die Strukturierung der Oberfläche der Tragstruktur und damit der Informationsgehalt des Musters wird beispielsweise durch Fräsen oder Schleifen der Tragstruktur gebildet. Das Muster kann auch beispielsweise ein lithografisch hergestelltes Muster sein.

Insbesondere ist die Bildauswerteeinrichtung eine digitale Schaltung oder in einer digitalen Baugruppe integriert. Die Bildauswerteeinrichtung kann beispielsweise Teil der Bild-Rekonstruktions-Vorrichtung sein.

Unter einer integrierten Baugruppe ist eine Anordnung mit einer Anzahl von integrierten Schaltungen und/oder Bauteilen zu verstehen, die auf einer Trägerleiterplatte oder mehreren Trägerleiterplatten angeordnet sind. Die integrierte Baugruppe kann auch als integrierte Sensorelektronik bezeichnet werden.

Unter einer "integrierten Schaltung" ist vorliegend eine auf einem einzigen Halbleitersubstrat (Wafer) angeordnete elektronische Schaltung (auch als monolithischer Schaltkreis bezeichnet) zu verstehen.

Die digitale Schaltung ist beispielsweise eine programmierbare digitale Schaltung (field-programmable gate array, FPGA) oder eine anwendungsspezifische digitale Schaltung (application-specific integrated circuit, ASIC).

Gemäß einem dritten Aspekt wird eine Lithographieanlage mit einem Projektionssystem mit zumindest einem Spiegel aufweisend die Positionssensorvorrichtung gemäß dem zweiten Aspekt vorgeschlagen.

Die Lithographieanlage ist insbesondere eine EUV- oder DUV-Lithographieanordnung. EUV steht für "Extreme Ultraviolett" und bezeichnet eine Wellenlänge des Arbeitslichts zwischen 0,1 und 30 nm. DUV steht für "Deep Ultraviolett" und bezeichnet eine Wellenlänge des Arbeitslichts zwischen 30 und 250 nm.

Gemäß einem vierten Aspekt wird ein Verfahren zum Betreiben eines Bildsensors, insbesondere eines Bildsensors gemäß des ersten Aspekts, vorgeschlagen. In einem ersten Schritt wird auf eine Einstrahlfläche einer Mehrzahl N2 von Einstrahlflächen einfallendes Licht in einen zugeordneten integrierten Lichtwellenleiter einer Mehrzahl N1 von integrierten Lichtwellenleitern eingekoppelt. In einem zweiten Schritt wird ein Lichtsignal in dem zugeordneten integrierten Lichtwellenleiter der Mehrzahl N1 von integrierten Lichtwellenleitern erzeugt. In einem dritten Schritt wird die Mehrzahl N1 von integrierten Lichtwellenleitern mit einer Multiplexer-Vorrichtung gekoppelt. In einem vierten Schritt werden die in den N1 integrierten Lichtwellenleitern erzeugten Lichtsignale auf eine Anzahl N3 sekundärer Lichtwellenleiter mittels der Multiplexer-Vorrichtung gemultiplext. In einem fünften Schritt werden die N3 sekundären Lichtwellenleiter mit einer Bild-Rekonstruktions-Vorrichtung gekoppelt und in einem sechsten Schritt wird mittels der Bild-Rekonstruktions-Vorrichtung ein Bild in Abhängigkeit der Lichtsignale der N3 sekundären Lichtwellenleiter rekonstruiert.

Mit diesem Verfahren kann vorteilhaft ein Bildsensor betrieben werden, bei dem die Bilderfassung in Form von Lichtsignalen und die Wandlung der erfassten Lichtsignale in elektrische Signale räumlich getrennt voneinander stattfindet.

Weiterhin wird ein Computerprogrammprodukt vorgeschlagen, welches auf einer programmgesteuerten Einrichtung die Durchführung des wie oben erläuterten Verfahrens veranlasst.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Die für den vorgeschlagenen Bildsensor beschriebenen Ausführungsformen und Merkmale gelten für das vorgeschlagene Verfahren entsprechend.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
Fig. 1 zeigt eine schematische Ansicht einer EUV-Lithographieanlage;
Fig. 2 zeigt eine schematische Ansicht eines Querschnitts eines ersten Ausführungsbeispiels eines Bildsensors;
Fig. 3 zeigt eine schematische Ansicht eines Querschnitts eines zweiten Ausführungsbeispiels eines Bildsensors;
Fig. 4 zeigt eine schematische Ansicht eines Querschnitts eines dritten Ausführungsbeispiels eines Bildsensors;
Fig. 5 zeigt eine schematische Ansicht eines Querschnitts eines vierten Ausführungsbeispiels eines Bildsensors;
Fig. 6 zeigt eine schematische Detailansicht eines Querschnitts eines fünften Ausführungsbeispiels eines Bildsensors;
Fig. 7 zeigt eine schematische Ansicht eines Querschnitts eines sechsten Ausführungsbeispiels eines Bildsensors;
Fig. 8 zeigt eine schematische Ansicht eines Querschnitts eines siebten Ausführungsbeispiels eines Bildsensors;
Fig. 9 zeigt eine schematische Ansicht eines Ausführungsbeispiels einer Positionssensorvorrichtung;
Fig. 10 zeigt eine Draufsicht auf ein Ausführungsbeispiel eines integriert-optischen Bildsensors; und
Fig. 11 zeigt ein Blockschaltbild eines Ausführungsbeispiels eines Verfahrens zum Betreiben eines Bildsensors.

In den Figuren sind gleiche oder funktionsgleiche Elemente mit denselben Bezugszeichen versehen worden, sofern nichts anderes angegeben ist. Ferner sind die Darstellungen in den Figuren nicht notwendigerweise maßstabsgerecht.

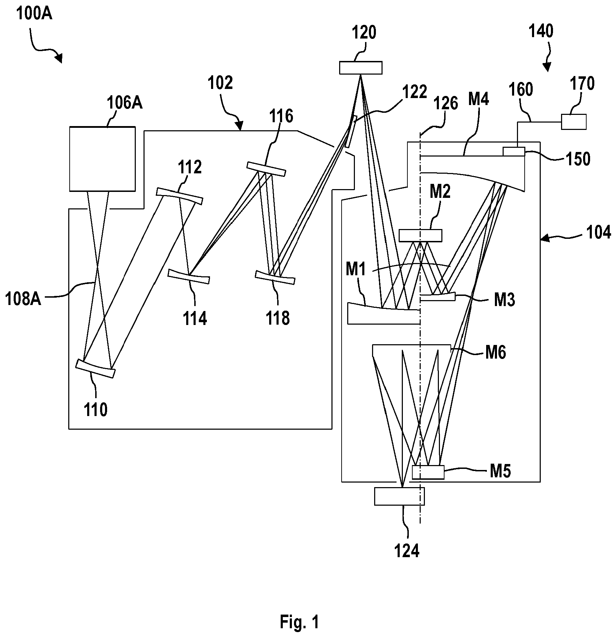

Fig. 1 zeigt eine schematische Ansicht einer EUV-Lithographieanlage 100A, welche ein Strahlformungs- und Beleuchtungssystem 102 und ein Projektionssystem 104 umfasst. Dabei steht EUV für "extremes Ultraviolett" (Engl.: extreme ultraviolet, EUV) und bezeichnet eine Wellenlänge des Arbeitslichts zwischen 0,1 und 30 nm. Das Strahlformungs- und Beleuchtungssystem 102 und das Projektionssystem 104 sind jeweils in einem Vakuum-Gehäuse vorgesehen, wobei jedes Vakuum-Gehäuse mit Hilfe einer nicht näher dargestellten Evakuierungsvorrichtung evakuiert wird. Die Vakuum-Gehäuse sind von einem nicht näher dargestellten Maschinenraum umgeben, in welchem z.B. elektrische Steuerungen und dergleichen vorgesehen sind.

Die EUV-Lithographieanlage 100A weist eine EUV-Lichtquelle 106A auf. Als EUV-Lichtquelle 106A kann beispielsweise eine Plasmaquelle vorgesehen sein, welche Strahlung 108A im EUV-Bereich (extrem ultravioletten Bereich), also z.B. im Wellenlängenbereich von 5 nm bis 30 nm aussendet. Im Strahlformungs- und Beleuchtungssystem 102 wird die EUV-Strahlung 108A gebündelt und die gewünschte Betriebswellenlänge aus der EUV-Strahlung 108A herausgefiltert. Die von der EUV-Lichtquelle 106A erzeugte EUV-Strahlung 108A weist eine relativ niedrige Transmissivität durch Luft auf, weshalb die Strahlführungsräume im Strahlformungs- und Beleuchtungssystem 102 und im Projektionssystem 104 evakuiert sind.

Das in Fig. 1 dargestellte Strahlformungs- und Beleuchtungssystem 102 weist fünf Spiegel 110, 112, 114, 116, 118 auf. Nach dem Durchgang durch das Strahlformungs- und Beleuchtungssystem 102 wird die EUV-Strahlung 108A auf die Photomaske (Engl.: reticle) 120 geleitet. Die Photomaske 120 ist ebenfalls als reflektives optisches Element ausgebildet und kann außerhalb der Systeme 102, 104 angeordnet sein. Weiter kann die EUV-Strahlung 108A mittels eines Spiegels 122 auf die Photomaske gelenkt werden. Die Photomaske 120 weist eine Struktur auf, welche mittels des Projektionssystems 104 verkleinert auf einen Wafer 124 oder dergleichen abgebildet wird.

Das Projektionssystem 104 weist sechs Spiegel M1 - M6 zur Abbildung der Photomaske 120 auf den Wafer 124 auf. Dabei können einzelne Spiegel M1 - M6 des Projektionssystems 104 symmetrisch zur optischen Achse 126 des Projektionssystems 104 angeordnet sein. Es sollte beachtet werden, dass die Anzahl der Spiegel der EUV-Lithographieanlage 100A nicht auf die dargestellte Anzahl beschränkt ist. Es können auch mehr oder weniger Spiegel vorgesehen sein. Des Weiteren sind die Spiegel M1 - M6 i.d.R. an ihrer Vorderseite zur Strahlformung gekrümmt.

Das Projektionssystem 104 weist ferner eine Anzahl von Positionssensorvorrichtungen 140 zur Ermittlung einer Position eines der Spiegel M1 - M6 auf. Ohne Einschränkung der Allgemeinheit und aus Gründen der vereinfachten Darstellung zeigt Fig. 1 eine Positionssensorvorrichtung 140. Die gezeigte Positionssensorvorrichtung 140 umfasst eine interne Gruppe 150, die in dem evakuierten Gehäuse des Projektionssystems 104 angeordnet ist, und eine externe Gruppe 170, die außerhalb des Gehäuses angeordnet ist, wobei eine Signalverbindung 160 Signale, insbesondere optische und elektrische Signale, zwischen der internen Gruppe 150 und der externen Gruppe 170 überträgt.

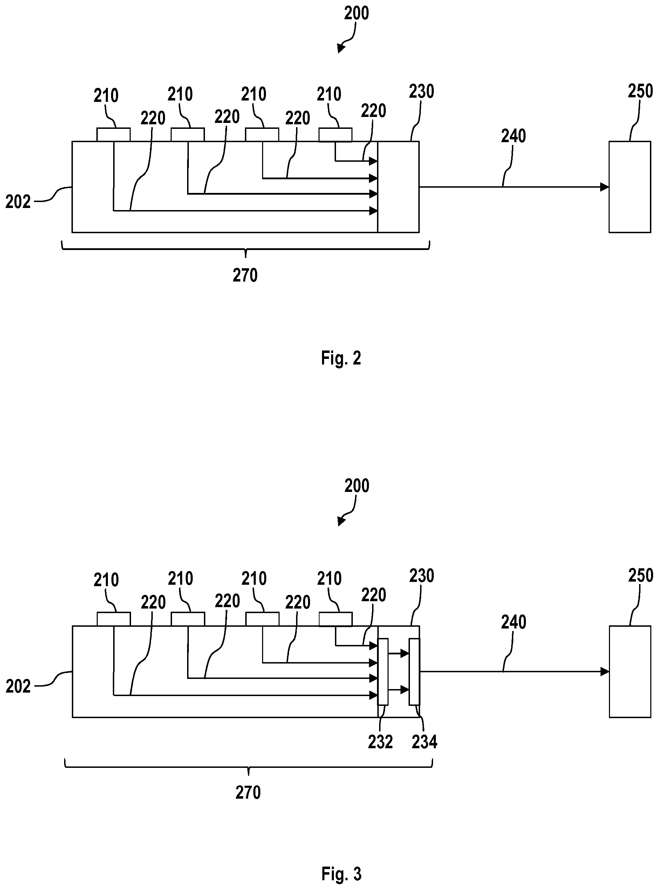

Die interne Gruppe 150 der Positionssensorvorrichtung 140 umfasst insbesondere eine mit dem jeweiligen Spiegel M1 - M6 gekoppelte Musterbereitstellungseinrichtung 142 und ein Sensor-Frontend 270, welches beispielsweise ein Substrat 202 mit einem integriert-optischen Schaltkreis aufweist (siehe Fig. 2 - 8).

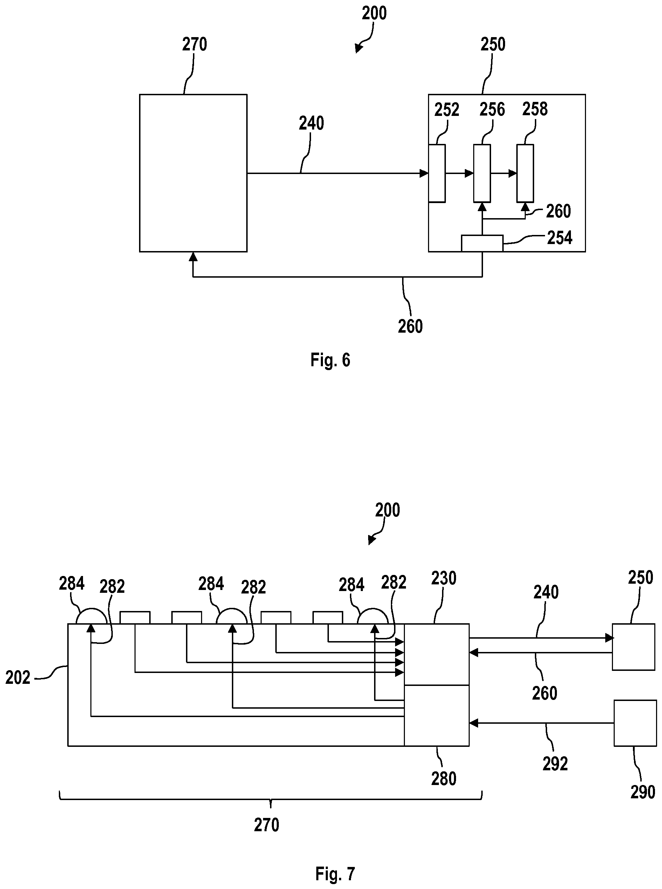

Die Signalverbindung 160 umfasst insbesondere eine Anzahl N3 von sekundären Lichtwellenleitern 240 (siehe Fig. 2 - 10), eine Anzahl N4 von Beleuchtungs-Lichtwellenleitern 292 (siehe Fig. 7, 9 oder 10) sowie zumindest ein elektrisches Signalkabel zur Übertragung eines Synchronisationssignals 260 (siehe Fig. 6, 7, 9 oder 10).

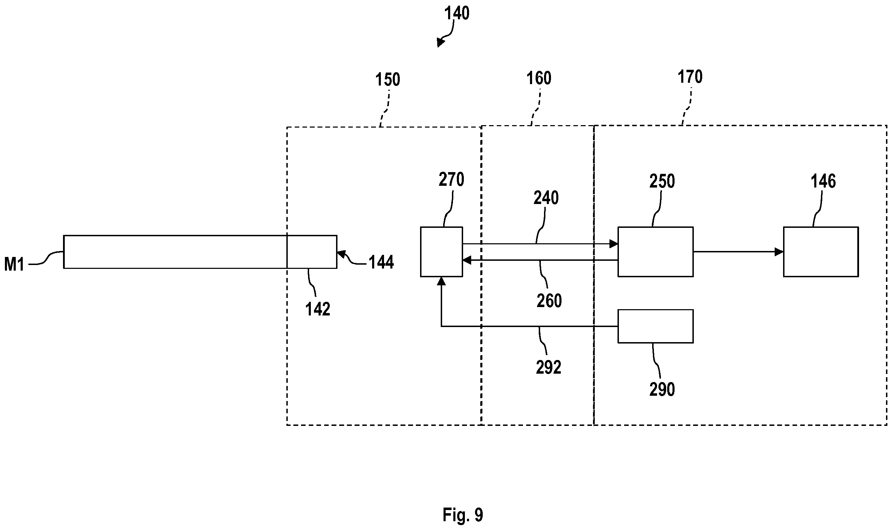

Die externe Gruppe 170 der Positionssensorvorrichtung 140 umfasst insbesondere eine Bild-Rekonstruktions-Vorrichtung 250 (siehe Fig. 2 - 9) und eine Bildauswerteeinrichtung 146 (siehe Fig. 9) sowie optional eine Beleuchtungseinrichtung 290 (siehe Fig. 7 oder 9).

Falls eine Mehrzahl an Positionssensorvorrichtungen 140 vorgesehen ist, kann vorteilhaft vorgesehen sein, eine Mehrzahl von internen Gruppen 150 über eine jeweilige Signalverbindung 160 mit einer geringeren Mehrzahl an externen Gruppen 170 zu koppeln. Insbesondere kann, wenn für einen Spiegel M1 - M6 eine Positionsbestimmung in sechs Achsen erwünscht ist, wofür beispielsweise sechs der internen Gruppen 150 benötigt werden, nur eine externe Gruppe 170 für diese sechs internen Gruppen 150 die Erfassung und Auswertung der Bildsignale übernehmen. Damit liefert diese eine externe Gruppe 170 eine komplette Positionsinformation in sechs Achsen für den überwachten Spiegel M1 - M6.

Fig. 2 zeigt eine schematische Ansicht eines Querschnitts eines ersten Ausführungsbeispiels eines Bildsensors 200, der beispielsweise in der Positionssensorvorrichtung 140 der Fig. 1 verwendet werden kann. Der Bildsensor 200 umfasst ein Sensor-Frontend 270 mit einem Substrat 202 mit mehreren integriert-optischen Elementen 210, 220, 230, sowie einen sekundären Lichtwellenleiter 240 und eine Bild-Rekonstruktions-Vorrichtung 250.

In diesem Beispiel weist das Substrat 202 N2 = 4 Einstrahlflächen 210 auf, welche dazu eingerichtet sind, auf sie einfallendes Licht in den jeweiligen der N1 = 4 integrierten Lichtwellenleiter 220 einzukoppeln, so dass in diesem ein Lichtsignal erzeugt wird. Die vier integrierten Lichtwellenleiter 220 leiten die Lichtsignale zu einer auf demselben Substrat 202 angeordneten integriert-optischen Multiplexer-Vorrichtung 230. In dieser Ansicht sind die vier integrierten Lichtwellenleiter 220 in unterschiedlich tiefen Schichten des Substrats 202 angeordnet. Dies dient jedoch lediglich der Übersichtlichkeit der Darstellung. In einem tatsächlichen Substrat 202 können die N1 integrierten Lichtwellenleiter in der gleichen Schicht nebeneinander und/oder in unterschiedlichen Schichten übereinander angeordnet sein.

Die Multiplexer-Vorrichtung 230 ist dazu eingerichtet, die zugeführten Lichtsignale auf einen mit ihr gekoppelten sekundären Lichtwellenleiter 240 zu multiplexen. In diesem Ausführungsbeispiel handelt es sich um eine 4x1 Multiplexer-Vorrichtung 230. Der sekundäre Lichtwellenleiter 240 ist beispielsweise als eine Glasfaser mit einer Länge von 10 m ausgebildet. Die Glasfaser 240 leitet das von der Multiplexer-Vorrichtung 230 eingekoppelte Lichtsignal an die Bild-Rekonstruktions-Vorrichtung 250 weiter.

Die Bild-Rekonstruktions-Vorrichtung 250 erfasst das zugeführte Lichtsignal und rekonstruiert in Abhängigkeit des Lichtsignals ein Bild. Das rekonstruierte Bild entspricht insbesondere einem auf einer Oberfläche des Substrats 202 vorhandenen Bild. Details der Bild-Rekonstruktions-Vorrichtung 250 sind beispielsweise in Fig. 6 dargestellt.

Fig. 3 zeigt eine schematische Ansicht eines Querschnitts eines zweiten Ausführungsbeispiels eines Bildsensors 200, der beispielsweise in der Positionssensorvorrichtung 140 der Fig. 1 verwendet werden kann. Das zweite Ausführungsbeispiel weist abweichend von dem ersten Ausführungsbeispiel (siehe Fig. 2) eine integriert-optische Multiplexer-Vorrichtung 230 mit zwei Stufen 232, 234 auf, ist ansonsten aber identisch. Durch die Verwendung mehrerer Multiplexer-Stufen 232, 234 lässt sich beispielsweise eine Komplexität eines Aufbaus der Multiplexer-Vorrichtung 230 reduzieren.

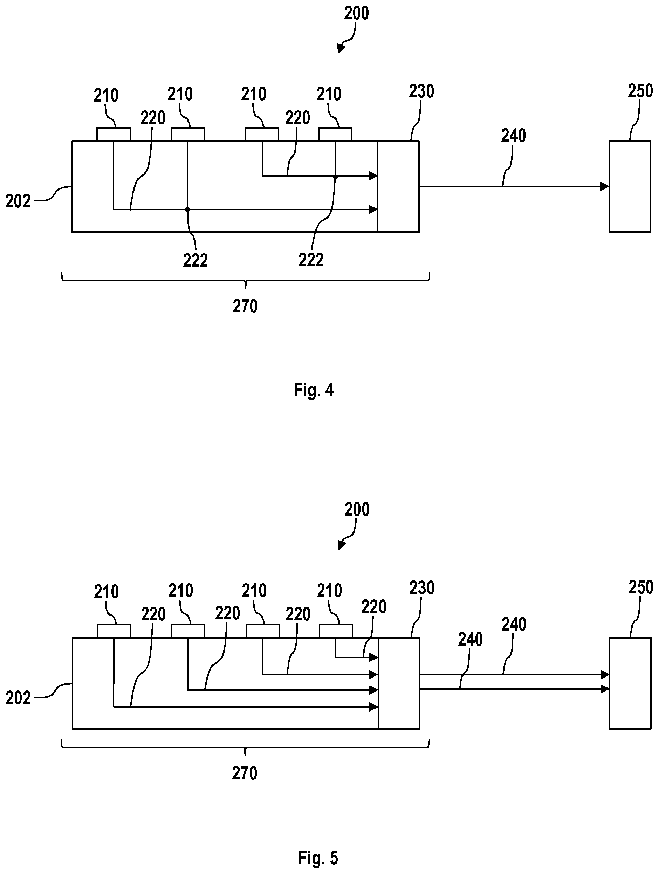

Fig. 4 zeigt eine schematische Ansicht eines Querschnitts eines dritten Ausführungsbeispiels eines Bildsensors 200, der beispielsweise in der Positionssensorvorrichtung 140 der Fig. 1 verwendet werden kann. Das dritte Ausführungsbeispiel unterscheidet sich von dem ersten Ausführungsbeispiel (siehe Fig. 2) dadurch, dass die Mehrzahl N1 = 2 integrierter Lichtwellenleiter 220 reduziert ist. Jeder der zwei integrierten Lichtwellenleiter 220 weist hier zwei diesem zugeordnete Einstrahlflächen 210 auf (N2 = 4), wobei von den jeweiligen Einstrahlflächen 210 in dem integrierten Lichtwellenleiter 220 erzeugte Lichtsignale an einer Zusammenführung 222 in dem integrierten Lichtwellenleiter 220 zusammengeführt werden. Jeder der integrierten Lichtwellenleiter 220 in diesem Beispiel übermittelt damit zwei Lichtsignale. Die Lichtsignale können sich beispielsweise in ihrer Polarisation oder in ihrer Frequenz unterscheiden, womit sie durch ein entsprechendes Filter diskriminiert werden können. Die weiteren Eigenschaften des Bildsensors 200 sind identisch zu dem ersten Ausführungsbeispiel.

Fig. 5 zeigt eine schematische Ansicht eines Querschnitts eines vierten Ausführungsbeispiels eines Bildsensors 200, der beispielsweise in der Positionssensorvorrichtung 140 der Fig. 1 verwendet werden kann. Im Unterschied zu dem ersten Ausführungsbeispiel (siehe Fig. 2) sind hier zwei sekundäre Lichtwellenleiter 240 vorgesehen. Demnach ist die dargestellte Multiplexer-Vorrichtung 230 als ein 4x2-Multiplexer ausgebildet. Die Bild-Rekonstruktions-Vorrichtung 250 ist entsprechend dazu eingerichtet, die Lichtsignale der beiden sekundären Lichtwellenleiter 240 zu erfassen und in Abhängigkeit der erfassten Lichtsignale das Bild zu rekonstruieren. Die weiteren Details entsprechen jenen des ersten Ausführungsbeispiels.

Fig. 6 zeigt eine schematische Ansicht eines Querschnitts eines fünften Ausführungsbeispiels eines Bildsensors 200, der beispielsweise in der Positionssensorvorrichtung 140 der Fig. 1 verwendet werden kann. In diesem sechsten Ausführungsbeispiel ist insbesondere die Bild-Rekonstruktions-Vorrichtung 250 detailliert dargestellt. Auf die Darstellung der Details des Sensor-Frontends 270 wurde aus Gründen der Übersicht verzichtet (siehe dazu beispielsweise Fig. 2 - 5, 7, 8 oder 10).

Die Bild-Rekonstruktions-Vorrichtung 250 weist demnach eine Erfassungseinrichtung 252 auf, die hier als eine Photodiode ausgebildet ist und die dazu eingerichtet ist, die von dem sekundären Lichtwellenleiter 240 zugeführten Lichtsignale zu erfassen und in ein elektrisches Signal zu wandeln. Das von der Photodiode 252 erzeugte elektrische Signal korreliert insbesondere mit einer Helligkeit oder Intensität eines jeweiligen Lichtsignals. Das von der Photodiode 252 erzeugte elektrische Signal wird einem Analog-Digital-Wandler 256 (A/D-Wandler) zugeführt. Ferner kann vorgesehen sein, dass das elektrische Signal der Photodiode 252 einem Verstärker zugeführt wird (nicht dargestellt), der das elektrische Signal verstärkt und das verstärkte Signal an den A/D-Wandler 256 ausgibt., Der A/D-Wandler 256 wandelt das elektrische Signal in ein digitales Datensignal um. Das digitale Datensignal ist beispielsweise eine 12-bit Bitfolge, die eine Helligkeitsinformation umfasst. Mit diesem digitalen Datensignal sind somit 4096 Helligkeitsstufen unterscheidbar. Ein einzelnes digitales Datensignal umfasst auf diese Weise eine Information, die von dem auf die entsprechende Einstrahlfläche 210 einfallenden Licht abhängt. Das digitale Datensignal wird an einen Bildprozessor 258 ausgegeben. Aus einer Mehrzahl von N2 empfangenen digitalen Datensignalen rekonstruiert der Bildprozessor 258 ein Bild mit N2 Bildpunkten, das bezüglich des Informationsgehalts dem Bild, das auf der Sensoroberfläche des Sensor-Frontends 270 ist, entspricht.

Weiterhin weist die Bild-Rekonstruktions-Vorrichtung 250 eine Synchronisationseinrichtung 254 auf. Die Synchronisationseinrichtung 254 ist als ein Taktgeber ausgebildet und stellt ein Synchronisationssignal 260 bereit. Dieses Synchronisationssignal 260 oder ein davon abgeleitetes Synchronisationssignal wird einerseits über eine elektrische Signalleitung an die Multiplexer-Vorrichtung 230 übertragen und andererseits auch an den A/D-Wandler 256 und den Bildprozessor 258 übertragen. Das Synchronisationssignal 260 dient dazu, die Multiplexer-Vorrichtung 230, den A/D-Wandler 256 sowie den Bildprozessor 258 zu synchronisieren. Die Synchronisationseinrichtung 254 wirkt so mit der Multiplexer-Vorrichtung 230, dem A/D-Wandler 256 und dem Bildprozessor 258 zusammen, dass eine eindeutige Zuordnung eines von der Erfassungseinheit 252 erfassten Lichtsignals zu einer der N2 Einstrahlflächen 210 gewährleistet ist. So lässt sich jedes digitale Datensignal eindeutig dem richtigen Bildpunkt für das rekonstruierte Bild zuordnen.

Fig. 7 zeigt eine schematische Ansicht eines Querschnitts eines sechsten Ausführungsbeispiels eines Bildsensors 200, der beispielsweise in der Positionssensorvorrichtung 140 der Fig. 1 verwendet werden kann. Dieses sechste Ausführungsbeispiel weist insbesondere die Merkmale des ersten Ausführungsbeispiels (siehe Fig. 2) und des fünften Ausführungsbeispiels (siehe Fig. 6) auf, wobei die Details der Bild-Rekonstruktions-Vorrichtung 250 hier aus Gründen der Übersicht nicht dargestellt sind. Ferner wurde auf die Bezugszeichen für die Einstrahlflächen 210 und die integrierten Lichtwellenleiter 220 aus Gründen der Übersicht verzichtet (siehe z.B. Fig. 2).

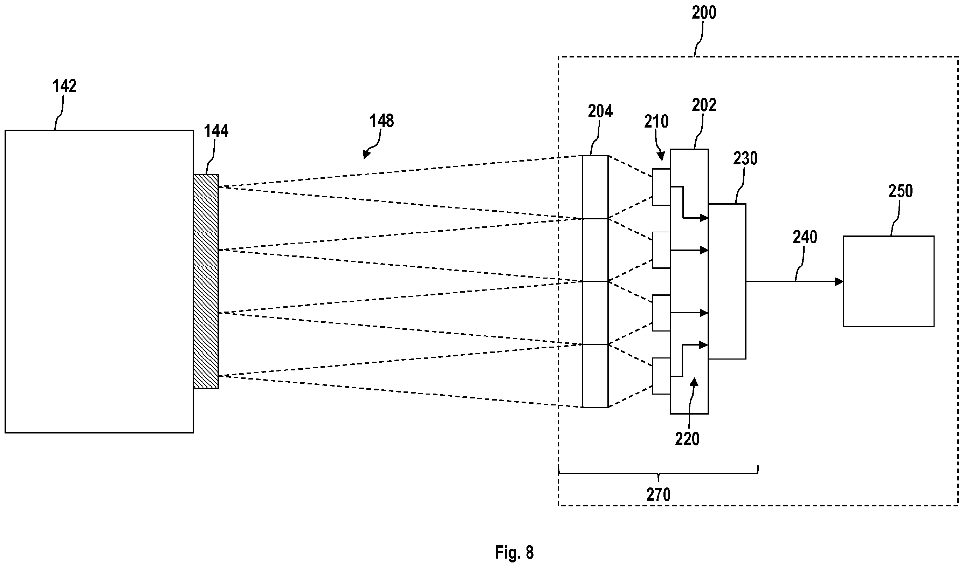

Das sechste Ausführungsbeispiel des Bildsensors 200 ist zusätzlich dazu eingerichtet, Licht zur Beleuchtung, beispielsweise eines Musters 144 (siehe z.B. Fig. 8 oder Fig. 9), bereitzustellen. Hierzu weist das Sensor-Frontend 270 zusätzliche integriert-optische Strukturen auf. Insbesondere weist das Substrat 202 N4 = 3 sekundäre integrierte Lichtwellenleiter 282 auf, die dazu eingerichtet sind, ein Lichtsignal zu auf einer Oberfläche des Substrats 202 angeordneten N5 = 3 Ausstrahlflächen 284 zu leiten. Über die drei Ausstrahlflächen 284 kann das Lichtsignal aus den drei sekundären integrierten Lichtwellenleitern 282 austreten. Ferner ist eine integriert-optische Verteiler-Vorrichtung 280 vorgesehen, welche ein von extern zugeführtes Lichtsignal auf die drei sekundären integrierten Lichtwellenleiter 282 verteilt.

Zur Erzeugung des Lichtsignals ist eine Beleuchtungseinrichtung 290 vorgesehen, die beispielsweise als eine Laserdiode ausgebildet ist. Die Laserdiode 290 erzeugt zunächst ein Lichtsignal in einem Beleuchtungs-Lichtwellenleiter 292, der beispielsweise als eine Glasfaser ausgebildet ist. Die Glasfaser 292 kann beispielsweise eine Länge von über 10 m haben. Damit ist die Laserdiode 290 flexibel anordenbar, insbesondere an einem Ort, an dem eine effiziente Kühlung einfach realisierbar ist. Alternativ oder zusätzlich zu einer Laserdiode kann eine weitere Beleuchtungseinrichtung 290, beispielsweise eine Lichtbogenlampe oder sonstige Lichtquelle, vorgesehen sein (nicht dargestellt). Ferner kann anstelle einer Glasfaser ein Glasfaserbündel vorgesehen sein (nicht dargestellt).

Die Glasfaser 292 ist an die Verteiler-Vorrichtung 280 gekoppelt. Die Verteiler-Vorrichtung 280 ist in diesem Beispiel als eine passive integriert-optische Struktur auf dem gleichen Substrat 202 angeordnet, wie die weiteren integriert-optischen Strukturen des Sensor-Frontends 270 des Bildsensors 200. Die Verteiler-Vorrichtung 280 verteilt das von der Glasfaser 292 eingekoppelte Lichtsignal auf die drei sekundären integrierten Lichtwellenleiter 282, welche das Lichtsignal zu den drei Ausstrahlflächen 284 leiten, welche das Lichtsignal aus den sekundären integrierten Lichtwellenleitern 282 austreten lassen.

In diesem sechsten Ausführungsbeispiel der Fig. 7 sind drei sekundäre integrierte Lichtwellenleiter 282 und drei Ausstrahlflächen 284 gezeigt. Abweichend hiervon können auch mehr oder weniger sekundäre integrierte Lichtwellenleiter 282 und/oder Ausstrahlflächen 284 vorgesehen sein. Ferner kann eine abweichende Anordnung insbesondere der Ausstrahlflächen 284 vorgesehen sein, beispielsweise nur am Rand des Substrats 202. Es kann auch vorgesehen sein, dass die Verteiler-Vorrichtung 280, die sekundären integrierten Lichtwellenleiter 282 und die Ausstrahlflächen 284 auf einem eigenen Substrat 202, das heißt getrennt von den Einstrahlflächen 210, integrierten Lichtwellenleitern 220 und/oder der Multiplexer-Vorrichtung 230, angeordnet sind. In diesem Fall würde das Sensor-Frontend 270 zwei Substrate 202 umfassen (nicht dargestellt).

Fig. 8 zeigt eine schematische Ansicht eines Querschnitts eines siebten Ausführungsbeispiels eines Bildsensors 200, der beispielsweise in der Positionssensorvorrichtung 140 der Fig. 1 verwendet werden kann. Der Bildsensor 200 des siebten Ausführungsbeispiels weist ein Substrat 202 mit vier Einstrahlflächen 210 und vier integrierte Lichtwellenleiter 220 auf. Die Multiplexer-Vorrichtung 230 ist in diesem Ausführungsbeispiel auf einem separaten integriert-optischen Bauteil angeordnet, welches derart neben dem Substrat 202 angeordnet ist, dass sie Lichtsignale von den integrierten Lichtwellenleitern 220 auf den sekundären Lichtwellenleiter 240 multiplexen kann. Die Multiplexer-Vorrichtung 230 ist als ein 4x1 Multiplexer ausgebildet. Die Bild-Rekonstruktions-Vorrichtung 250 ist dazu eingerichtet, in Abhängigkeit von den von dem sekundären Lichtwellenleiter 240 zugeführten Lichtsignalen ein Bild zu rekonstruieren.

Insbesondere weist der Bildsensor 200 in diesem Ausführungsbeispiel eine Abbildungsvorrichtung 204 auf, die räumlich vor dem Substrat 202 auf der Seite der Einstrahlflächen 210 angeordnet ist. Die Abbildungsvorrichtung 204 ist als eine Mikrooptik ausgebildet, die dazu eingerichtet ist, einen abzubildenden Gegenstandspunkt, vorliegend des Musters 144, auf eine Einstrahlfläche 210 abzubilden. Dies ist durch die gestrichelt gezeichneten Lichtstrahlen 148 angedeutet. Die Mikrooptik 204 erzeugt demnach eine Abbildung des Musters 144 auf der Sensoroberfläche, auf der die Einstrahlflächen 210 angeordnet sind.

Das Sensor-Frontend 270 umfasst in diesem Ausführungsbeispiel somit die Mikrooptik 204, das Substrat 202 mit den Einstrahlflächen 210 und integrierten Lichtwellenleitern 220, sowie die Multiplexer-Vorrichtung 230.

In der Fig. 8 ist neben dem Bildsensor 200 auch eine Musterbereitstellungseinrichtung 142 gezeigt, welche das Muster 144 bereitstellt. Das Muster 144 weist insbesondere einen Informationsgehalt bei vorbestimmten Ortsfrequenzen auf, der es erlaubt, eine relative Verschiebung des Musters 144 aus einer Referenzposition zu bestimmen, beispielsweise einen Informationsgehalt bei 1/(500 µm). Der benötigte Informationsgehalt des Musters 144 als auch die benötigte Auflösung des Bildsensors 200 hängen insbesondere von der erwünschten Genauigkeit der Bestimmung einer solchen relativen Verschiebung ab. Die Auflösung des Bildsensors 200 entspricht insbesondere der Mehrzahl N2 an Einstrahlflächen 210.

Fig. 9 zeigt eine schematische Ansicht eines Ausführungsbeispiels einer Positionssensorvorrichtung 140, die beispielsweise zur Ermittlung einer Position eines Spiegels M1 - M6 einer EUV-Lithographieanlage 100A, wie in der Fig. 1 dargestellt, verwendbar ist. Die Positionssensorvorrichtung 140 umfasst die, ebenfalls in der Fig. 1 dargestellte, interne Gruppe 150, die externe Gruppe 170 sowie die Signalverbindung 160.

Die interne Gruppe 150 weist einerseits die Musterbereitstellungseinrichtung 142 mit dem Muster 144 auf, die an einem Spiegel M1, der beispielsweise Teil eines Projektionssystems 104 der EUV-Lithographieanlage 100A ist (siehe Fig. 1), angeordnet ist, dessen Position vorliegend überwacht oder bestimmt werden soll. Daneben weist die interne Gruppe 150 das Sensor-Frontend 270 auf. Aus Gründen der Übersicht sind hier keine Details des Sensor-Frontends 270 dargestellt. Das Sensor-Frontend 270 kann insbesondere wie in einem der in den Fig. 2 - 8 dargestellten Ausführungsbeispiele ausgebildet sein.

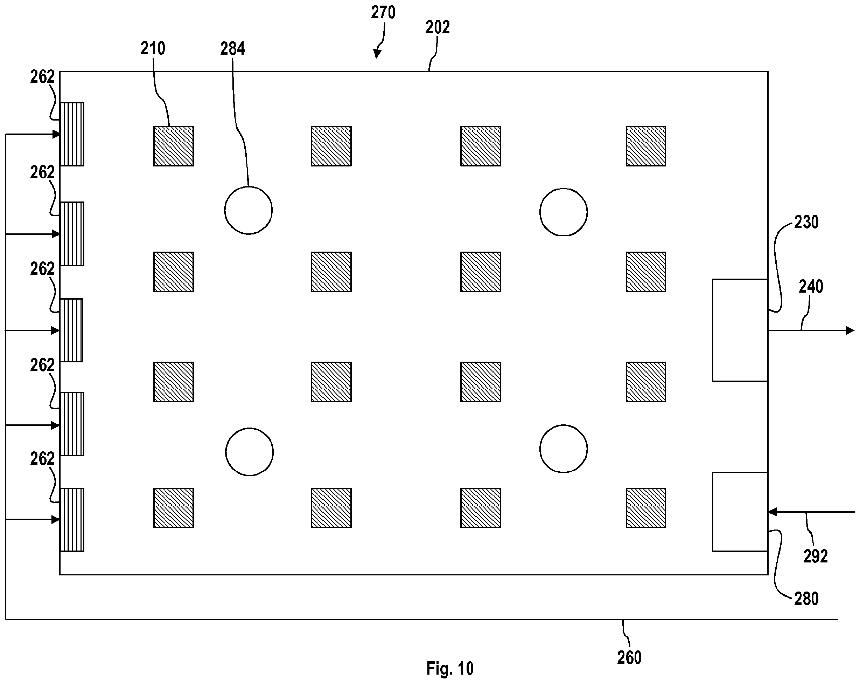

Fig. 10 zeigt eine Draufsicht auf ein Ausführungsbeispiel eines Sensor-Frontends 270, welches vorliegend in einem einzigen Substrat 202 integriert ist. Das dargestellte Ausführungsbeispiel ist beispielsweise in einer Positionssensorvorrichtung 140 der Fig. 1 oder 9 verwendbar.

In dem Ausführungsbeispiel sind nur die auf der Oberfläche des Substrats 202 angeordneten Baugruppen/Funktionseinheiten dargestellt, die in dem Substrat 202 in einer tieferen Schicht vergrabenen Funktionseinheiten sind nicht gezeigt. Dies sind insbesondere integrierte Lichtwellenleiter 220 (siehe Fig. 2 - 8), sekundäre integrierte Lichtwellenleiter 282 (siehe Fig. 7) sowie elektronische Signalverbindungen.

Auf der Oberfläche angeordnet sind bei dem dargestellten Ausführungsbeispiel N2 = 16 Einstrahlflächen 210, die in einer rechteckigen 4x4-Matrixanordnung angeordnet sind. Nur eine der Einstrahlflächen 210 wurde mit einem Bezugszeichen gekennzeichnet, um die Darstellung übersichtlich zu halten. Weiterhin sind N5 = 4 Ausstrahlflächen 284 zwischen den Einstrahlflächen 210 angeordnet. Wiederum ist lediglich eine der Ausstrahlflächen 284 mit einem Bezugszeichen gekennzeichnet. In der Zeichnung auf der rechten Seite des Substrats 202 ist eine Multiplexer-Vorrichtung 230 angeordnet, die mit einem sekundären Lichtwellenleiter 240 gekoppelt ist. Jede der Einstrahlflächen 210 ist dazu eingerichtet, ein Lichtsignal in einem integrierten Lichtwellenleiter 220 (nicht dargestellt), dem sie zugeordnet ist, zu erzeugen. Die integrierten Lichtwellenleiter 220 leiten die Lichtsignale zu der Multiplexer-Vorrichtung 230, welche sie gemäß eines vorgegebenen Multiplexing-Verfahrens an den sekundären Lichtwellenleiter 240 weitergibt. In der Zeichnung unterhalb der Multiplexer-Vorrichtung 230, ebenfalls auf der rechten Seite des Substrats 202, ist eine Verteiler-Vorrichtung 280 angeordnet. Diese ist mit einem Beleuchtungs-Lichtwellenleiter 292 gekoppelt. Der Beleuchtungs-Lichtwellenleiter 292 führt beispielsweise ein monochromatisches Lichtsignal, das von einer nicht dargestellten Beleuchtungs-Vorrichtung 290 (siehe z.B. Fig. 7 oder 9), z.B. einer Laserquelle, erzeugt wird, der Verteiler-Vorrichtung 280 zu. Die Verteiler-Vorrichtung 280 verteilt das Lichtsignal auf eine Anzahl N4 sekundärer integrierter Lichtwellenleiter 282 (nicht dargestellt), die das Lichtsignal den vier Ausstrahlflächen 284 zuführen, über welche das Lichtsignal aus den sekundären integrierten Lichtwellenleitern 282 auskoppeln kann.

In der Zeichnung auf der linken Seite des Substrats 202 sind insgesamt fünf Kontaktstellen 262 angeordnet, denen über eine Signalleitung beispielsweise das Synchronisationssignal 260 zugeführt wird. Die Kontaktstellen 262 sind zur Ansteuerung der Multiplexer-Vorrichtung 230 mit dieser über nicht dargestellte, in dem Substrat 202 integrierte elektrische Signalleitungen verbunden. Jeder der Kontaktstellen 262 kann ein individuelles Steuersignal mittels des Synchronisationssignals 260 zugeführt werden. Alternativ zu dieser Darstellung kann vorgesehen sein, die Kontaktstellen 262 auf der Rückseite des Substrats 202 anzuordnen.

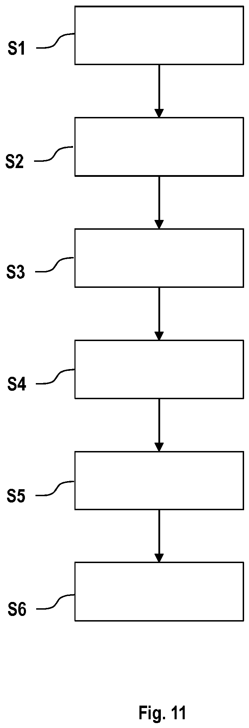

Fig. 11 zeigt ein Blockschaltbild eines Ausführungsbeispiels eines Verfahrens zum Betreiben eines Bildsensors 200, beispielsweise des Bildsensors 200 eines der Ausführungsbeispiele der Fig. 2 - 8.

In einem ersten Verfahrensschritt S1 wird Licht von einer Einstrahlfläche 210 in einen integrierten Lichtwellenleiter 220 eingekoppelt. In einem zweiten Verfahrensschritt S2 wird ein Lichtsignal in dem zugeordneten integrierten Lichtwellenleiter 220 erzeugt. In einem dritten Verfahrensschritt wird die Mehrzahl N1 der integrierten Lichtwellenleiter 220 mit einer Multiplexer-Vorrichtung 230 gekoppelt. Die Multiplexer-Vorrichtung 230 ist dazu eingerichtet, in einem vierten Verfahrensschritt S4 die Lichtsignale auf eine Anzahl N3 sekundärer Lichtwellenleiter 240 zu multiplexen. In einem fünften Verfahrensschritt S5 wird die Anzahl N3 sekundärer Lichtwellenleiter 240 mit einer Bild-Rekonstruktions-Vorrichtung 250 gekoppelt. Die Bild-Rekonstruktions-Vorrichtung 250 erfasst die Lichtsignale und rekonstruiert ein Bild in Abhängigkeit der erfassten Lichtsignale in einem sechsten Verfahrensschritt S6.

Obwohl die vorliegende Erfindung anhand von Ausführungsbeispielen beschrieben wurde, wird die Erfindung durch die Ansprüche definiert.

### BEZUGSZEICHENLISTE

- 100: Lithographieanlage
- 100A: EUV-Lithographieanlage
- 102: Strahlformungs- und Beleuchtungssystem
- 104: Projektionssystem
- 106A: EUV-Lichtquelle
- 108A: EUV-Strahlung
- 110: Spiegel
- 112: Spiegel
- 114: Spiegel
- 116: Spiegel
- 118: Spiegel
- 120: Photomaske
- 122: Spiegel
- 124: Wafer
- 126: optische Achse des Projektionssystems
- 136: Spiegel
- 137: Vakuum-Gehäuse
- 140: Positionssensorvorrichtung
- 142: Musterbereitstellungseinrichtung
- 144: Muster
- 146: Bildauswerteeinrichtung
- 148: Lichtstrahlen
- 150: interne Gruppe
- 160: Signalverbindung
- 170: externe Gruppe
- 200: Bildsensor
- 202: Substrat
- 204: Abbildungseinheit
- 210: Einstrahlfläche
- 220: integrierter Lichtwellenleiter
- 230: Multiplexer-Vorrichtung
- 232: Multiplexer-Stufe
- 234: Multiplexer-Stufe
- 240: sekundärer Lichtwellenleiter
- 250: Bild-Rekonstruktions-Vorrichtung
- 252: Erfassungseinrichtung
- 254: Synchronisationseinrichtung
- 256: Analog-Digital-Wandler
- 258: Bildprozessor
- 260: Synchronisationssignal
- 262: Kontaktstelle
- 270: Sensor-Frontend
- 280: Verteiler-Vorrichtung
- 282: sekundäre integrierte Lichtwellenleiter
- 284: Ausstrahlfläche
- 290: Beleuchtungseinrichtung
- 292: Beleuchtungs-Lichtwellenleiter

- M1: Spiegel
- M2: Spiegel
- M3: Spiegel
- M4: Spiegel
- M5: Spiegel
- M6: Spiegel
- S1: Verfahrensschritt
- S2: Verfahrensschritt
- S3: Verfahrensschritt
- S4: Verfahrensschritt
- S5: Verfahrensschritt
- S6: Verfahrensschritt

## Patentansprüche

1. Bildsensor (200) für eine Positionssensorvorrichtung (140) zum Ermitteln einer Position zumindest eines Spiegels (M1 - M6) einer Lithographieanlage (100, 100A), mit:
einer Mehrzahl N1 von integrierten Lichtwellenleitern (220),
einer Mehrzahl N2 von Einstrahlflächen (210), mit N2 ≥ N1, wobei eine jeweilige der N2 Einstrahlflächen (210) einem der N1 integrierten Lichtwellenleiter (220) zugeordnet und dazu eingerichtet ist, einfallendes Licht in den zugeordneten integrierten Lichtwellenleiter (220) derart einzukoppeln, dass ein Lichtsignal in dem zugeordneten integrierten Lichtwellenleiter (220) erzeugt wird,
einer mit den N1 integrierten Lichtwellenleitern (220) gekoppelten Multiplexer-Vorrichtung (230) zum Multiplexen der in den N1 integrierten Lichtwellenleitern (220) erzeugten Lichtsignale auf eine Anzahl N3 von sekundären Lichtwellenleiten (240), mit N1 ≥ N3, und
einer mit den N3 sekundären Lichtwellenleitern (240) gekoppelten Bild-Rekonstruktions-Vorrichtung (250) zum Rekonstruieren eines Bildes in Abhängigkeit der Lichtsignale der N3 sekundären Lichtwellenleiter (240),wobei die Mehrzahl N2 von Einstrahlflächen (210), die Mehrzahl N1 von integrierten Lichtwellenleitern (220) und die Multiplexer-Vorrichtung (230) auf einem Substrat (202), insbesondere einem einstückigen Substrat (202), integriert sind.

2. Bildsensor gemäß Anspruch 1, wobei die Multiplexer-Vorrichtung (230) dazu eingerichtet ist, die Lichtsignale mittels eines Zeitmultiplexverfahrens, eines Frequenzmultiplexverfahrens und/oder eines Codemultiplexverfahrens zu multiplexen.

3. Bildsensor gemäß Anspruch 1 oder 2, wobei die Multiplexer-Vorrichtung (230) eine Anzahl von schaltbaren integriert-optischen Strukturen aufweist, wobei in Abhängigkeit einer Schaltposition einer jeweiligen schaltbaren integriert-optischen Struktur das Lichtsignal von einem der N1 integrierten Lichtwellenleiter (220) auf einen der N3 sekundären Lichtwellenleiter (240) gemultiplext wird.

4. Bildsensor gemäß einem der Ansprüche 1 bis 3, wobei die Bild-Rekonstruktions-Vorrichtung (250) eine Erfassungseinrichtung (252) zum Erfassen der Lichtsignale der N3 sekundären Lichtwellenleiter (240) und eine Synchronisationseinrichtung (254) aufweist, wobei die Synchronisationseinrichtung (254) dazu eingerichtet ist, die Multiplexer-Vorrichtung (230) mittels eines Synchronisationssignals (260) derart anzusteuern, dass ein jeweiliges von der Erfassungseinrichtung (252) erfasstes Lichtsignal eindeutig einer Einstrahlfläche (210) der Mehrzahl N2 von Einstrahlflächen (210) des Bildsensors (200) zuordenbar ist.

5. Bildsensor gemäß einem der Ansprüche 1 bis 4, wobei eine Oberfläche einer jeweiligen Einstrahlfläche (210) der Mehrzahl N2 von Einstrahlflächen (210) einen vorbestimmten Winkel zu dem einfallenden Licht aufweist.

6. Bildsensor gemäß einem der Ansprüche 1 bis 5, umfassend eine Abbildungseinheit (204) zum Abbilden eines mit dem Bildsensor (200) zu erfassenden Musters (144) einer Musterbereitstellungseinrichtung (142) auf die Mehrzahl N2 von Einstrahlflächen (210) des Bildsensors (200).

7. Bildsensor gemäß einem der Ansprüche 1 bis 6, umfassend eine Anzahl N4 von sekundären integrierten Lichtwellenleitern (282) und eine Anzahl N5 von Ausstrahlflächen (284), mit N5 ≥ N4, wobei eine jeweilige der N5 Ausstrahlflächen (284) einem der N4 sekundären integrierten Lichtwellenleiter (282) zugeordnet und dazu eingerichtet ist, ein in dem zugeordneten sekundären integrierten Lichtwellenleiter (282) erzeugtes Lichtsignal zum Beleuchten eines mit dem Bildsensor (200) zu erfassenden Musters (144) einer Musterbereitstellungseinrichtung (142) aus dem zugeordneten sekundären integrierten Lichtwellenleiter (282) auszukoppeln.

8. Bildsensor gemäß Anspruch 7, umfassend eine Beleuchtungseinrichtung (290) zum Erzeugen eines Lichtsignals in einem Beleuchtungs-Lichtwellenleiter (292) und eine mit dem Beleuchtungs-Lichtwellenleiter (292) gekoppelte Verteiler-Vorrichtung (280) zum Verteilen des in dem Beleuchtungs-Lichtwellenleiter (292) erzeugten Lichtsignals auf die Anzahl N4 von sekundären integrierten Lichtwellenleitern (282).

9. Bildsensor gemäß Anspruch 7 oder 8, wobei die Anzahl N4 von sekundären integrierten Lichtwellenleitern (282) und die Anzahl N5 von Ausstrahlflächen (284) und/oder die Verteiler-Vorrichtung (280) auf dem Substrat (202) integriert sind.

10. Bildsensor gemäß einem der Ansprüche 1 bis 9, wobei 16 ≤ N2 ≤ 16384, insbesondere 256 ≤ N2 ≤ 4096 ist.

11. Bildsensor gemäß einem der Ansprüche 1 bis 10, wobei dass eine Strukturgröße der N1 integrierten Lichtwellenleiter (220) und/oder der N4 sekundären integrierten Lichtwellenleiter (282) unter 100 µm, vorzugsweise unter 10 µm, insbesondere unter 1 µm, ist.

12. Bildsensor gemäß einem der Ansprüche 1 bis 11, wobei eine Kantenlänge eines Pixels des Bildsensors (200) zwischen 5 µm und 1 mm, insbesondere zwischen 40 µm und 160 µm liegt.

13. Positionssensorvorrichtung (140) zum Ermitteln einer Position zumindest eines Spiegels (M1 - M6) einer Lithographieanlage (100, 100A), mit:
einer mit dem Spiegel (M1 - M6) gekoppelte Musterbereitstellungseinrichtung (142) zur Bereitstellung eines Musters (144), welches einen Informationsgehalt bei Ortsfrequenzen von zumindest 1/(500 µm) aufweist,
einem Bildsensor (200) gemäß einem der Ansprüche 1 bis 12 zum Erfassen des bereitgestellten Musters (144) und zum Bereitstellen eines rekonstruierten Bildes des erfassten Musters (144), und
einer Bildauswerteeinrichtung (146) zum Ermitteln der Position des Spiegels (M1 - M6) in Abhängigkeit des rekonstruierten Bildes.

14. Lithographieanlage (100, 100A) mit einem Projektionssystem (104) mit zumindest einem Spiegel (M1 - M6) aufweisend die Positionssensorvorrichtung (140) gemäß Anspruch 13.

15. Verfahren zum Betreiben eines Bildsensors (200) für eine Positionssensorvorrichtung (140) zum Ermitteln einer Position zumindest eines Spiegels (M1 - M6) einer Lithographieanlage (100, 100A), mit
Einkoppeln (S1) von auf eine Einstrahlfläche (210) einer Mehrzahl N2 von Einstrahlflächen (210) einfallendem Licht in einen zugeordneten integrierten Lichtwellenleiter (220) einer Mehrzahl N1 von integrierten Lichtwellenleitern (220),
Erzeugen (S2) eines Lichtsignals in dem zugeordneten integrierten Lichtwellenleiter (220) der Mehrzahl N1 von integrierten Lichtwellenleitern (220),
Koppeln (S3) der Mehrzahl N1 von integrierten Lichtwellenleitern (220) mit einer Multiplexer-Vorrichtung (230),
Multiplexen (S4) der in den N1 integrierten Lichtwellenleitern (220) erzeugten Lichtsignale auf eine Anzahl N3 sekundärer Lichtwellenleiter (240) mittels der Multiplexer-Vorrichtung (230),
Koppeln (S5) der N3 sekundären Lichtwellenleiter (240) mit einer Bild-Rekonstruktions-Vorrichtung (250), und
Rekonstruieren (S6) eines Bildes in Abhängigkeit der Lichtsignale der N3 sekundären Lichtwellenleiter (240) mittels der Bild-Rekonstruktions-Vorrichtung (250), wobei
die Mehrzahl N2 von Einstrahlflächen (210), die Mehrzahl N1 von integrierten Lichtwellenleitern (220) und die Multiplexer-Vorrichtung (230) auf einem Substrat (202), insbesondere einem einstückigen Substrat (202), integriert sind.

## Claims

1. Image sensor (200) for a position sensor apparatus (140) for ascertaining a position of at least one mirror (M1-M6) of a lithography apparatus (100, 100A), comprising:
a plurality N1 of integrated optical waveguides (220),
a plurality N2 of incoupling areas (210), with N2 ≥ N1, each of the N2 incoupling areas (210) being assigned to one of the N1 integrated optical waveguides (220) and configured to couple incident light into the assigned integrated optical waveguide (220) in such a way that a light signal is generated in the assigned integrated optical waveguide (220),
a multiplexer apparatus (230), coupled to the N1 integrated optical waveguides (220), for multiplexing the light signals generated in the N1 integrated optical waveguides (220) to a number N3 of secondary optical waveguides (240), with N1 ≥ N3, and
an image reconstruction apparatus (250), coupled to the N3 secondary optical waveguides (240), for reconstructing an image on the basis of the light signals of the N3 secondary optical waveguides (240), wherein
the plurality N2 of incoupling areas (210), the plurality N1 of integrated optical waveguides (220) and the multiplexer apparatus (230) are integrated on a substrate (202), in particular on an integral substrate (202).

2. Image sensor according to Claim 1, wherein the multiplexer apparatus (230) is configured to multiplex the light signals by means of a time-division multiplexing method, a frequency-division multiplexing method, and/or a codedivision multiplexing method.

3. Image sensor according to Claim 1 or 2, wherein the multiplexer apparatus (230) comprises a number of switchable integrated optical structures, wherein, depending on a switching position of a respective switchable integrated optical structure, the light signal is multiplexed from one of the N1 integrated optical waveguides (220) to one of the N3 secondary optical waveguides (240).

4. Image sensor according to any one of Claims 1 to 3, wherein the image reconstruction apparatus (250) comprises a capturing device (252) for capturing the light signals of the N3 secondary optical waveguides (240) and a synchronization device (254), the synchronization device (254) being configured to drive the multiplexer apparatus (230) by means of a synchronization signal (260) in such a way that a respective light signal captured by the capturing device (252) is uniquely assignable to an incoupling area (210) of the plurality N2 of incoupling areas (210) of the image sensor (200).

5. Image sensor according to any one of Claims 1 to 4, wherein a surface of a respective incoupling area (210) of the plurality N2 of incoupling areas (210) has a predetermined angle with respect to the incident light.

6. Image sensor according to any one of Claims 1 to 5, comprising an imaging unit (204) for imaging a pattern (144) of a pattern provision device (142), to be captured by the image sensor (200), on the plurality N2 of incoupling areas (210) of the image sensor (200).

7. Image sensor according to any one of Claims 1 to 6, comprising a number N4 of secondary integrated optical waveguides (282) and a number N5 of outcoupling areas (284), with N5 ≥ N4, each of the N5 outcoupling areas (284) being assigned to one of the N4 secondary integrated optical waveguides (282) and configured to output couple from the assigned secondary integrated optical waveguide (282) a light signal, generated in the assigned secondary integrated optical waveguide (282), for illuminating a pattern (144) of a pattern provision device (142) to be captured by the image sensor (200).

8. Image sensor according to Claim 7, comprising an illumination device (290) for generating a light signal in an illumination optical waveguide (292) and a distribution apparatus (280), coupled to the illumination optical waveguide (292), for distributing the light signal generated in the illumination optical waveguide (292) among the number N4 of secondary integrated optical waveguides (282).

9. Image sensor according to Claim 7 or 8, wherein the number N4 of secondary integrated optical waveguides (282) and the number N5 of outcoupling areas (284) and/or the distribution apparatus (280) are integrated on the substrate (202).

10. Image sensor according to any one of Claims 1 to 9, wherein 16 ≤ N2 ≤ 16384, in particular 256 ≤ N2 ≤ 4096 applies.

11. Image sensor according to any one of Claims 1 to 10, wherein the structure dimension of the N1 integrated optical waveguides (220) and/or of the N4 secondary integrated optical waveguides (282) is less than 100 µm, preferably less than 10 µm, in particular less than 1 µm.

12. Image sensor according to any one of Claims 1 to 11, wherein an edge length of a pixel of the image sensor (200) lies in the range between 5 µm and 1 mm, in particular between 40 µm and 160 µm.

13. Position sensor apparatus (140) for ascertaining a position of at least one mirror (M1-M6) of a lithography apparatus (100, 100A), comprising:
a pattern provision device (142), coupled to the mirror (M1-M6), for providing a pattern (144) which has information content at spatial frequencies of at least 1/(500 µm),
an image sensor (200) according to any one of Claims 1 to 12, for capturing the provided pattern (144) and for providing a reconstructed image of the captured pattern (144), and
an image evaluation device (146) for ascertaining the position of the mirror (M1-M6) on the basis of the reconstructed image.

14. Lithography apparatus (100, 100A) with a projection system (104) with at least one mirror (M1-M6) comprising the position sensor apparatus (140) according to Claim 13.

15. Method for operating an image sensor (200) for a position sensor apparatus (140) for ascertaining a position of at least one mirror (M1-M6) of a lithography apparatus (100, 100A), including:
coupling (S1) light, incident on an incoupling area (210) of a plurality N2 of incoupling areas (210), into an assigned integrated optical waveguide (220) of a plurality N1 of integrated optical waveguides (220),
generating (S2) a light signal in the assigned integrated optical waveguide (220) of the plurality N1 of integrated optical waveguides (220),
coupling (S3) the plurality N1 of integrated optical waveguides (220) with a multiplexer apparatus (230),
multiplexing (S4) the light signals, generated in the N1 integrated optical waveguides (220), to a number N3 of secondary optical waveguides (240) by means of the multiplexer apparatus (230),
coupling (S5) the N3 secondary optical waveguides (240) with an image reconstruction apparatus (250), and
reconstructing (S6) an image on the basis of the light signals of the N3 secondary optical waveguides (240) by means of the image reconstruction apparatus (250), wherein
the plurality N2 of incoupling areas (210), the plurality N1 of integrated optical waveguides (220) and the multiplexer apparatus (230) are integrated on a substrate (202), in particular on an integral substrate (202).

## Revendications

1. Capteur d'image (200) destiné à un dispositif formant capteur de position (140) destiné à déterminer une position d'au moins un miroir (Ml - M6) d'une installation de lithographie (100, 100A), ledit capteur d'image comprenant :
une pluralité N1 de guides d'ondes lumineuses intégrées (220),
une pluralité N2 de surfaces de rayonnement entrant (210), avec N2 ≥ N1, une surface de rayonnement entrant respective parmi les N2 surfaces de rayonnement entrant (210) étant associée à l'un des N1 guides d'ondes lumineuses intégrés (220) et étant conçue pour injecter par couplage la lumière incidente dans le guide d'ondes lumineuses intégré associé (220) de manière à générer un signal lumineux dans le guide d'ondes lumineuses intégré associé (220),
un dispositif formant multiplexeur (230) couplé aux N1 guides d'ondes lumineuses intégrés (220) afin de multiplexer les signaux lumineux générés dans les N1 guides d'ondes lumineuses intégrés (220) vers un nombre N3 de guides d'ondes lumineuses secondaires (240), avec N1 ≥ N3, et
un dispositif de reconstruction d'image (250) couplé aux N3 guides d'ondes lumineuses secondaires (240) pour reconstruire une image en fonction des signaux lumineux des N3 guides d'ondes lumineuses secondaires (240), la pluralité N2 de surfaces de rayonnement entrant (210), la pluralité N1 de guides d'ondes lumineuses intégrés (220) et le dispositif formant multiplexeur (230) étant intégrés sur un substrat (202), notamment un substrat monobloc (202).

2. Capteur d'images selon la revendication 1, le dispositif formant multiplexeur (230) étant conçu pour multiplexer les signaux lumineux à l'aide d'un procédé de multiplexage temporel, d'un procédé de multiplexage fréquentiel et/ou d'un procédé de multiplexage par code.

3. Capteur d'images selon la revendication 1 ou 2, le dispositif formant multiplexeur (230) comportant un certain nombre de structures optiques intégrées commutables, le signal lumineux étant multiplexé depuis l'un des N1 guides d'ondes lumineuses intégrés (220) vers l'un des N3 guides d'ondes lumineuses secondaires (240) en fonction d'une position de commutation d'une structure optique intégrée commutable respective.

4. Capteur d'images selon l'une des revendications 1 à 3, le dispositif de reconstruction d'image (250) comportant un module de détection (252) destiné à détecter les signaux lumineux des N3 guides d'ondes lumineuses secondaires (240) et un module de synchronisation (254), le module de synchronisation (254) étant conçu pour commander le dispositif formant multiplexeur (230) au moyen d'un signal de synchronisation (260) de manière à pouvoir associer un signal lumineux respectif, détecté par le module de détection (252), de manière univoque à une surface de rayonnement entrant (210) de la pluralité N2 de surfaces de rayonnement entrant (210) du capteur d'images (200).

5. Capteur d'images selon l'une des revendications 1 à 4, une aire d'une surface de rayonnement entrant respective (210) de la pluralité N2 de surfaces de rayonnement entrant (210) formant un angle prédéterminé par rapport à la lumière incidente.

6. Capteur d'images selon l'une des revendications 1 à 5, comprenant une unité de reproduction (204) destinée à reproduire un motif (144), à détecter à l'aide du capteur d'images (200), d'un module de fourniture de motif (142) sur la pluralité N2 de surfaces de rayonnement entrant (210) du capteur d'images (200).

7. Capteur d'images selon l'une des revendications 1 à 6, comprenant un nombre N4 de guides d'ondes lumineuses intégrés secondaires (282) et un nombre N5 de surfaces de rayonnement sortant (284), avec N5 ≥ N4, une surface de rayonnement sortant respective parmi les N5 surfaces de rayonnement sortant (284) étant associée à l'un des N4 guides d'ondes lumineuses intégrés secondaires (282) et étant conçue pour délivrer en sortie par couplage un signal lumineux, généré dans le guide d'ondes lumineuses intégré secondaire associé (282), afin d'éclairer un motif (144), à détecter à l'aide du capteur d'images (200), d'un module de fourniture de motif (142) à partir du guide d'ondes lumineuses intégré secondaire associé (282).

8. Capteur d'images selon la revendication 7, comprenant un module d'éclairage (290) destiné à générer un signal lumineux dans un guide d'ondes lumineuses d'éclairage (292) et un module de distribution (280) couplé au guide d'ondes lumineuses d'éclairage (292) et destiné à distribuer le signal lumineux, généré dans le guide d'ondes lumineuses d'éclairage (292), vers le nombre N4 de guides d'ondes lumineuses intégrés secondaires (282).

9. Capteur d'images selon la revendication 7 ou 8, le nombre N4 de guides d'ondes lumineuses intégrés secondaires (282) et le nombre N5 de surfaces de rayonnement sortant (284) et/ou le dispositif de distribution (280) étant intégrés sur le substrat (202).

10. Capteur d'images selon l'une des revendications 1 à 9, avec 16 ≤ N2 ≤ 16384, en particulier 256 ≤ N2 ≤ 4096.

11. Capteur d'images selon l'une des revendications 1 à 10, une dimension de structure du guide d'ondes lumineuses intégré N1 (220) et/ou du guide d'ondes lumineuses intégré secondaire N4 (282) étant inférieure à 100 µm, de préférence inférieure à 10 µm, en particulier inférieure à 1 µm.

12. Capteur d'images selon l'une des revendications 1 à 11, une longueur de bord d'un pixel du capteur d'images (200) étant comprise entre 5 µm et 1 mm, en particulier entre 40 µm et 160 µm.

13. Dispositif formant capteur de position (140) destiné à déterminer une position d'au moins un miroir (Ml - M6) d'une installation de lithographie (100, 100A), ledit dispositif formant capteur de position comprenant :
un module de fourniture de motif (142) couplé au miroir (Ml - M6) et destiné à fournir un motif (144) qui comporte un contenu informationnel pour des fréquences spatiales d'au moins 1/(500 µm),
un capteur d'images (200) selon l'une des revendications 1 à 12 destiné à détecter le motif fourni (144) et à fournir une image reconstruite du motif détecté (144), et
un module d'évaluation d'image (146) destiné à déterminer la position du miroir (Ml - M6) en fonction de l'image reconstruite.

14. Installation de lithographie (100, 100A) comprenant un système de projection (104) pourvu d'au moins un miroir (Ml - M6) comportant le dispositif formant capteur de position (140) selon la revendication 13.

15. Procédé de fonctionnement d'un capteur d'images (200) destiné à un dispositif formant capteur de position (140) destiné à déterminer une position d'au moins un miroir (Ml - M6) d'une installation de lithographie (100, 100A), ledit procédé comprenant les étapes suivantes
injecter par couplage (S1) une lumière incidente sur une surface de rayonnement entrant (210) d'une pluralité N2 de surfaces de rayonnement entrant (210) dans un guide d'ondes lumineuses intégré associé (220) d'une pluralité N1 de guides d'ondes lumineuses intégrés (220),
générer (S2) un signal lumineux dans le guide d'ondes lumineuses intégré associé (220) de la pluralité N1 de guides d'ondes lumineuses intégrés (220),
coupler (S3) la pluralité N1 de guides d'ondes lumineuses intégrés (220) à un dispositif formant multiplexeur (230),
multiplexer (S4) les signaux lumineux, générés dans les N1 guides d'ondes lumineuses intégrés (220), vers un nombre N3 de guides d'ondes lumineuses secondaires (240) au moyen du dispositif formant multiplexeur (230),
coupler (S5) les N3 guides d'ondes lumineuses secondaires (240) à un dispositif de reconstruction d'image (250), et
reconstruire (S6) une image en fonction des signaux lumineux des N3 guides d'ondes lumineuses secondaires (240) à l'aide du dispositif de reconstruction d'image (250),
la pluralité N2 de surfaces de rayonnement entrant (210), la pluralité N1 de guides d'ondes lumineuses intégrés (220) et le dispositif formant multiplexeur (230) étant intégrés sur un substrat (202), notamment un substrat monobloc (202).
